# EUROPEAN PATENT APPLICATION

(11) **EP 4 718 969 A1**
(43) Date of publication of application: **01.04.2026**
(21) Application number: 25200746.3
(22) Date of filing: 08.09.2025
(51) Int. Cl.: H10B 12/00, H10D 30/63, H10D 30/67

(54) **SEMICONDUCTOR MEMORY DEVICE**

(30) Priority: 27.09.2024 KR 20240131514
(71) Applicant: Samsung Electronics Co., Ltd., Suwon-si, Gyeonggi-do 16677 (KR)
(72) Inventor: LEE, Hyunjin, 16677 Suwon-si (KR); KIM, Yongkwan, 16677 Suwon-si (KR); KIM, Huijung, 16677 Suwon-si (KR); CHAE, Heejae, 16677 Suwon-si (KR)
(74) Representative: Marks & Clerk LLP

(57) **Abstract**

The semiconductor device include a bit line extending in a first direction, a first gate electrode extending on the bit line in a second direction, a first gate insulation pattern including a first portion covering each of opposite sidewalls in the first direction and the end portion in the second direction of the first gate electrode and a second portion contacting the first portion and extending in the second direction, a channel extending in a third direction, the channel being disposed on a side in the first direction of the first gate insulation pattern on the bit line and a second gate insulation pattern and a second gate electrode sequentially arranged in the first direction on a side in the first direction of the channel on the bit line. An end portion in the second direction of the first gate electrode has a central portion with respect to the first direction, and the end portion protrudes in the second direction in a plan view.

## Description

### TECHNICAL FIELD

Example embodiments relate to a semiconductor device. More particularly, example embodiments relate to a semiconductor device including a vertical channel.

### DISCUSSION OF RELATED ART

A memory device including a vertical channel transistor has been developed to improve the integration of the memory device. The vertical channel transistor includes an offset region in which gate electrodes and contact plugs contacting the gate electrode are disposed, and an electrical short or leakage current may be generated due to misalignment between the gate electrodes and the contact plugs.

### SUMMARY

Example embodiments provide a semiconductor device having improved characteristics.

According to example embodiments, there is provided a semiconductor device. The semiconductor device may include a bit line extending in a first direction, a first gate electrode extending on the bit line in a second direction intersecting the first direction, a first gate insulation pattern including a first portion covering each of opposite sidewalls in the first direction and the end portion in the second direction of the first gate electrode and a second portion contacting the first portion and extending in the second direction, a channel extending in a third direction substantially perpendicular to the first and second directions, the channel being disposed on a side in the first direction of the first gate insulation pattern on the bit line and a second gate insulation pattern and a second gate electrode sequentially arranged in the first direction on a side in the first direction of the channel on the bit line. An end portion in the second direction of the first gate electrode has a central portion with respect to the first direction, and the end portion protrudes in the second direction in a plan view.

According to example embodiments, there is provided a semiconductor device. The semiconductor device may include bit lines spaced apart from each other in a first direction, each of the bit lines extending in a second direction intersecting the first direction, a first gate electrode extending in the first direction on the bit lines, a first gate insulation pattern including two parts on respective opposite sidewalls in the second direction of the first gate electrode, each of the two parts extending in the first direction, wherein the two parts of the first gate insulation pattern are merged at an end portion in the first direction of the first gate electrode, and the merged portion extends in the first direction, channels on and electrically connected to the bit lines, respectively, the channels being on respective opposite sidewalls in the second direction of the first gate insulation pattern, and the channels being spaced apart from each other, a second gate insulation pattern on the opposite sidewalls in the second direction of the first gate insulation pattern, the second gate insulation pattern extending in the first direction and surrounding sidewalls of the channels and a second gate electrode on each of opposite sidewalls in the second direction of the second gate insulation pattern, the second gate electrode extending in the first direction, wherein each of opposite outer sidewalls in the second direction of a portion of the first gate insulation pattern adjacent to the end portion in the first direction of the first gate electrode may have a curved shape in a plan view.

According to example embodiments, there is provided a semiconductor device. The semiconductor device may include a plurality of bit lines spaced apart from each other in a first direction, each of the plurality of bit lines extending in a second direction intersecting the first direction, a first gate electrode extending in the first direction on the plurality of bit lines, an end portion in the first direction of the first gate electrode having a central portion in the second direction that protrudes in the first direction, in a plan view, a first gate insulation pattern including a first portion covering each of opposite sidewalls in the second direction and the end portion in the first direction of the first gate electrode and a second portion contacting the first portion and extending in the first direction, a channel at each of opposite sides in the second direction of the first gate insulation pattern on the plurality of bit lines, the channel extending in a third direction substantially perpendicular to the first and second directions, a second gate insulation pattern and a second gate electrode sequentially stacked in the second direction at a side in the second direction of the channel on the plurality of bit lines, a capacitor on and electrically connected to the channel, a first contact plug contacting an upper surface of the first gate electrode and a second contact plug contacting an upper surface of the second gate electrode.

In the semiconductor device including the vertical channel transistor according to example embodiments, an electrical short or leakage currents due to misalignment may not be generated or may be reduced between the gate electrodes and the contact plugs on the gate electrodes. At least some of the above and other features of the invention are set out in the claims.

### BRIEF DESCRIPTION OF THE DRAWINGS

FIGS. 1A, 1B, 2 and 3 are a plan view and cross-sectional views illustrating a semiconductor device in accordance with example embodiments.
FIGS. 4 to 48 are plan views and cross-sectional views illustrating a method of manufacturing a semiconductor device according to example embodiments.

### DETAILED DESCRIPTION

The above and other aspects and features of the semiconductor devices and the methods of manufacturing the same in accordance with the example embodiments will become readily understood from detailed descriptions that follow, with reference to the accompanying drawings.

It will be understood that, although the terms "first," "second," and/or "third" may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

Items described in the singular herein may be provided in plural, as can be seen, for example, in the drawings. Thus, the description of a single item that is provided in plural should be understood to be applicable to the remaining plurality of items unless context indicates otherwise.

Throughout the specification, when a component is described as "including" a particular element or group of elements, it is to be understood that the component is formed of only the element or the group of elements, or the element or group of elements may be combined with additional elements to form the component, unless the context indicates otherwise. The term "consisting of," on the other hand, indicates that a component is formed only of the element(s) listed.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Hereinafter, two directions among horizontal directions that are substantially parallel to an upper surface of a first substrate 100, which may intersect or cross each other, may be referred to as first and second directions D1 and D2, respectively. Additionally, a direction substantially perpendicular to the upper surface of the first substrate 100 may be referred to as a third direction D3. Where the first substrate 100 is removed, the first direction D1 may be defined as a direction in which one or more first gate electrodes 210 extend, and the second direction D2 may be defined as a direction in which one or more bit lines 430 extend. Similarly, where the first substrate 100 is removed, the third direction D3 may be defined as a direction in which one or more channels 108 extend. In example embodiments, the first and second directions D1 and D2 may be substantially orthogonal to each other. Each of the first to third directions D1, D2 and D3 may refer not only to the directions shown in the figures, but also to the opposite directions thereto. The third direction D3 may define a vertical direction (e.g. for the purposes of determining whether components are "above" or "below" other components). It will be appreciated that these directions are defined relative to the structure of the device, and need not imply any particular orientation of the semiconductor device in use.

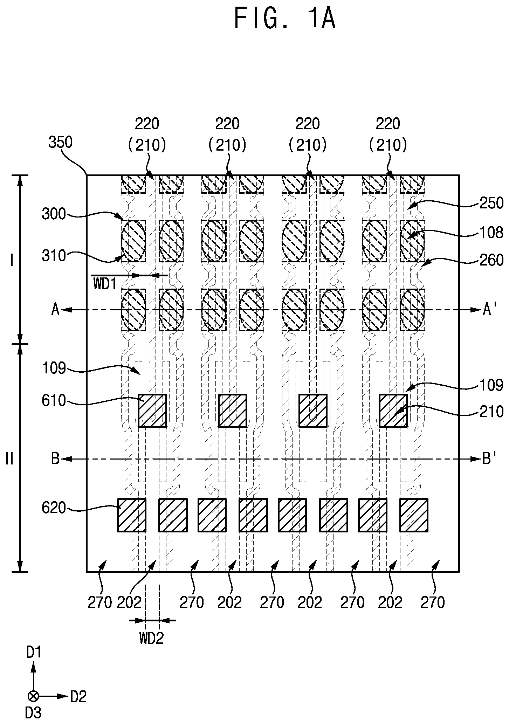

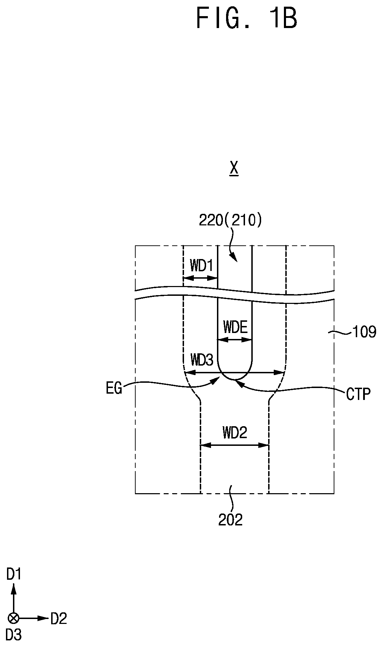

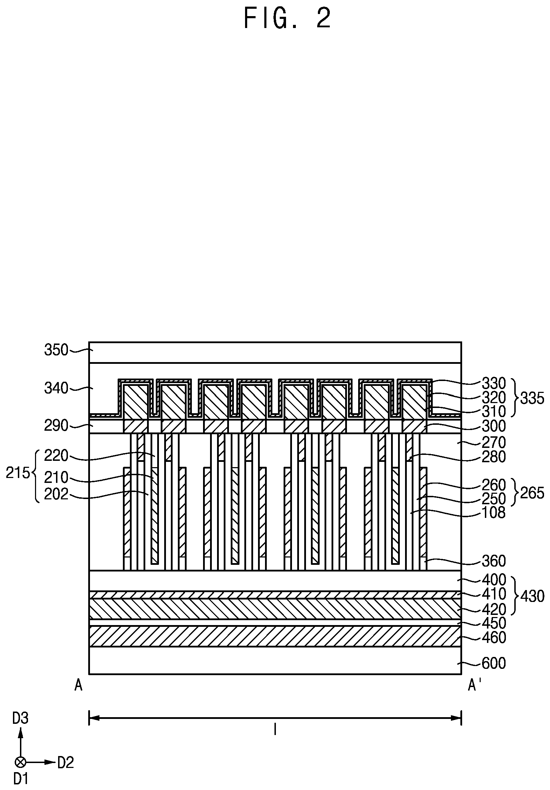

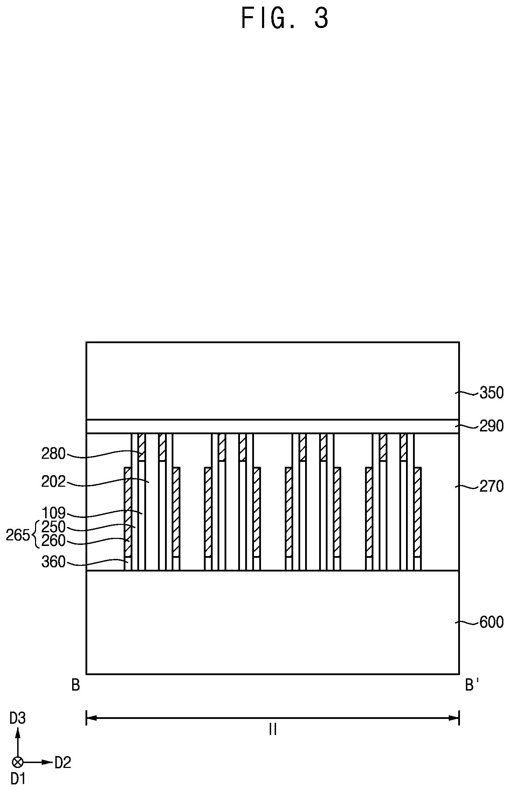

FIGS. 1A, 1B, 2 and 3 are plan views and cross-sectional views illustrating a semiconductor device in accordance with example embodiments. Particularly, FIGS. 1A and 1B are plan views, FIG. 2 is a cross-sectional view taken along line A-A' of FIG. 1A, and FIG. 3 is a cross-sectional view taken along line B-B' of FIG. 1A. A "plan view" may be a view along the third direction D3 (or a direction opposite to the third direction D3).

Referring to FIGS. 1A, 1B, 2 and 3, the semiconductor device may include a bit line shield structure 460, a bit line 430, first and second gate structures 215 and 265, a channel 108, a dummy channel 109, a gate division pattern 270, a landing pad 300 and a data storage element of a semiconductor memory device (e.g., capacitor structure). The semiconductor device may be a storage device or memory device, such as a direct random-access memory (DRAM) device. Having said this, embodiments are not limited to storage or memory devices, and the concepts discussed herein may equally be equally applied to any semiconductor device (e.g. any semiconductor device having one or more vertical channel transistors).

The semiconductor device may further include first to third insulating interlayers 290, 350 and 600, first and second insulation patterns 360 and 450, and first to third contact plugs 280, 610 and 620.

The semiconductor device may include first and second regions I and II. In example embodiments, the first region I may be a cell array region where memory cells are disposed, and the second region II may be a peripheral circuit region where at least a portion of peripheral circuit patterns are disposed. The peripheral circuit patterns may be elements of a peripheral circuitry for applying an electrical signal to the memory cells.

FIG. 1A shows that the first and second regions I and II are arranged in the first direction D1, but the inventive concept is not limited thereto, and for example, the first and second regions I and II may be arranged in the second direction D2, the second region II may surround the first region I, or the second region II may be disposed on each of opposite sides of the first region I in the first direction D1 or the second direction D2.

In an example embodiment, the semiconductor device may have a cell over periphery (COP) structure in which at least a portion of the peripheral circuit pattern may be disposed below the memory cells, or a periphery over cell (POC) structure in which at least a portion of the peripheral circuit pattern may be disposed above the memory cells.

The peripheral circuit pattern may include (or be, or be a part of), e.g., a transistor, a contact plug, a wiring, a via, etc. The peripheral circuitry may include, e.g., a bit line sense amplifier (BLSA), a sub-word line driver (SWD), a column decoder, a common select line (CSL) driver, an input/output sense amplifier (I/O) SA, a write driver, etc.

In example embodiments, a thickness in the third direction D3 of a second portion of the third insulating interlayer 600 disposed in the second region II may be greater than a thickness in the third direction D3 of a first portion of the third insulating interlayer 600 disposed in the first region I. The third insulating interlayer 600 may include an insulating material, e.g., silicon oxide (SiO₂), silicon nitride (SiN), a low-k material, etc. A low-k material may be a material having a dielectric constant this is lower than that of silicon oxide.

The bit line shield structure 460 may be disposed on the first portion of the third insulating interlayer 600.

In example embodiments, the bit line shield structure 460 may include a bit line shield plate and a bit line shield fin, which may be sequentially stacked in the third direction D3 and may be in contact with each other. In example embodiments, the bit line shield plate may have a flat plate shape. The bit line shield fin may protrude from the bit line shield plate in the third direction D3 and extend in the second direction D2, and a plurality of bit line shield fins may be spaced apart from each other in the first direction D1.

The bit line shield structure 460 may include a conductive material, e.g., a metal, a metal nitride, a metal silicide, etc.

The second insulation pattern 450 may cover an upper surface of the bit line shield structure 460. The second insulation pattern 450 may include an oxide, e.g., silicon oxide.

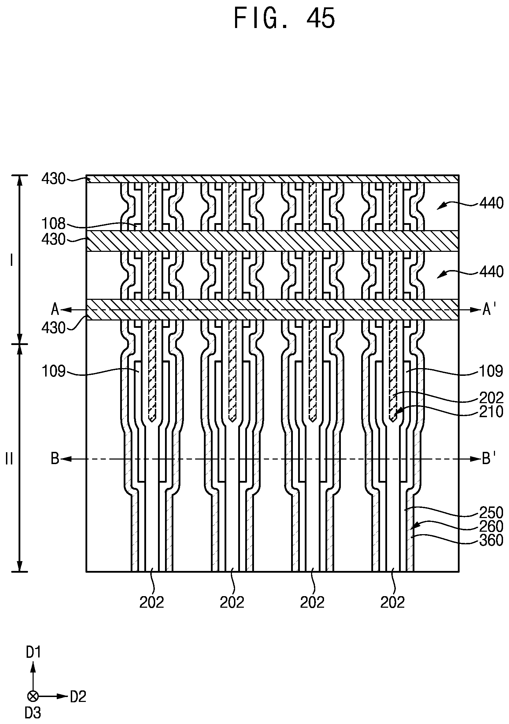

The bit line 430 may be disposed on the second insulation pattern 450 in the first region I. Referring to FIG. 1A together with FIG. 45, the bit line 430 may extend in the second direction D2, and a plurality of bit lines 430 may be spaced apart from each other in the first direction D1. Each of the bit lines 430 may be disposed between ones of the bit line shield fins adjacent to each other in the first direction D1, and a lower surface and sidewall thereof may be covered by the second insulation pattern 450. A "lower surface" of an object may be a bottom surface (e.g. may be a surface facing downwards). Similarly, an "upper surface" may be a top surface (e.g. may be a surface facing upwards).

In example embodiments, the bit line 430 may be a bit line formed of a composite layer including a second conductive pattern 420, a barrier pattern 410 and a first conductive pattern 400 sequentially stacked in the third direction D3. The second conductive pattern 420 may include a metal and/or a metal nitride, the barrier pattern 410 may include a metal silicon nitride, e.g., titanium silicon nitride, and the first conductive pattern 400 may include, e.g., polysilicon doped with impurities (charge carrier dopants).

The first gate structure 215 may be disposed on the third insulating interlayer 600, the bit line 430 and the second insulation pattern 450, and may extend in the first direction D1. A plurality of first gate structures 215 may be spaced apart from each other in the second direction D2.

In example embodiments, a lower surface of the first gate structure 215 may contact an upper surface of the bit line 430 and an upper surface of the second insulation pattern 450 between ones of the bit lines 430 adjacent to each other in the first direction D1 in the first region I. The lower surface of the first gate structure 215 may contact an upper surface of the third insulating interlayer 600 in the second region II.

The first gate structure 215 may include a first gate electrode 210, a first gate insulation pattern 202, which may cover each of opposite sidewalls in the second direction D2 and a lower surface of the first gate electrode 210, and a capping pattern 220, which may cover an upper surface of the first gate electrode 210. The term "sidewall in the X direction" may refer to a sidewall that faces in the X direction (e.g. that has a portion that is perpendicular to the X direction).

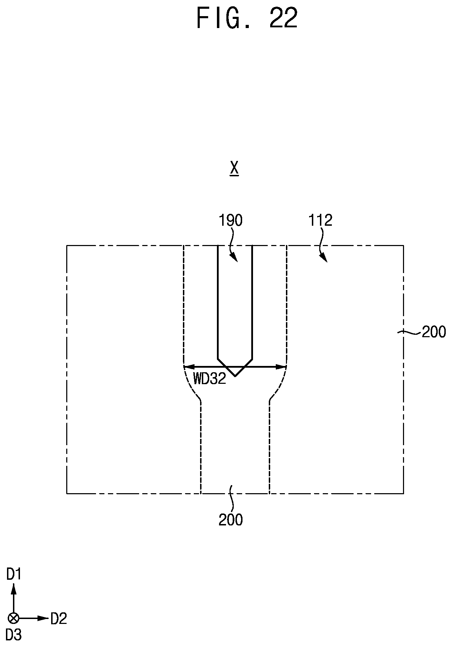

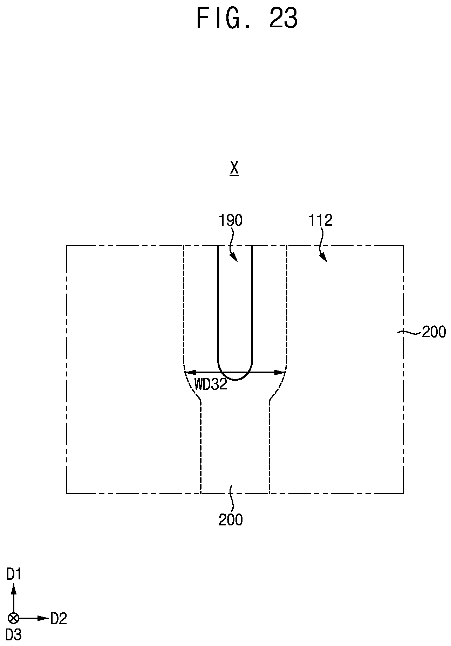

FIG. 1B is an enlarged plan view illustrating an end portion of the first gate electrode 210 (as well as the capping pattern 220). The first gate electrode 210 may have a pillar shape extending in the first direction D1 in the first region I, and may have an end portion in the first direction D1 in a portion of the second region II adjacent to the first region I. Referring to FIGS.1A and 1B together with FIG. 22 and FIG. 23, the end portion of the first gate electrode 210 may have, e.g., a pointed shape in a central portion CTP of the surface of the end portion, or a curved shape such as a semicircular shape, a rounded shape, etc., in a plan view. Thus, the end portion of the first gate electrode 210 may not be flat, and a central portion CTP in the second direction D2 of the end portion of the first gate electrode 210 may protrude in the first direction D1 as compared to an edge portion EG in the second direction D2 thereof. For example, the first gate electrode 210 may extend in the first direction D1. The central portion CTP may be located at the middle of the end portion of the first gate electrode 210, and the middle of the end portion may be the midpoint with respect to the second direction D2. In an embodiment, the end portion of the first gate electrode 210 may point the first direction by the central portion CTP.

The capping pattern 220 may be disposed on the first gate electrode 210 and may contact the upper surface thereof, and may have an end portion in the first direction D1 in the portion of the second region II adjacent to the first region I. The end portion of the capping pattern 220 in the first direction D1 may have substantially the same shape as the end portion in the first direction D1 of a corresponding one of the first gate electrodes 210. The end portion of the capping pattern 220 may have, e.g., a pointed shape in a central portion of the surface of the end portion, or a curved shape such as a semicircular shape, a rounded shape, etc., in a plan view. Thus, the end portion of the capping pattern 220 may not be flat, and the central portion CTP in the second direction D2 of the end portion may protrude in the first direction D1 as compared to an edge portion EG in the second direction D2 thereof.

For example, in a plan view, the first gate electrode 210 (as well as the capping pattern 220) may have a protruding end (or a pointed end, or a projecting end) in the D1 direction. The protruding end may have a protruding shape along the first direction D1. The protruding shape may be arranged such that the protruding end of the surface of the first gate electrode 210 (as well as the capping pattern 220) is oriented along or pointing to the first direction D1. The central portion CTP may be where the length of the first gate electrode 210 (as well as the capping pattern 220) in the first direction D1 is greatest. For example, the protruding end may have a rounded convex shape protruding, and, in a plan view, the protruding shape may be a curved shape having a radius of curvature. The radius of curvature of the central portion CTP may be less than 70% of a greatest width WDE of the protruding portion in the second direction D2.

The first gate insulation pattern 202 may partially surround the first gate electrode 210 and the capping pattern 220. The first gate insulation pattern 202 may include a first portion and a second portion. In a plan view, the first gate insulation pattern 202 may have a Y-shape such that the second portion splits into two parts of the first portion at the end portion of the first gate electrode 210 (or the capping pattern 220).

The first portion of the first gate insulation pattern 202 may extend in the first direction D1, and may cover opposite sidewalls in the second direction D2 and a lower surface of the first gate electrode 210. The opposite sidewalls of the first gate electrode 210 may face away from each other in the second direction D2. The first portion of the first gate insulation pattern 202 may further cover a sidewall in the first direction D1 and a lower surface of the end portion of the first gate electrode 210, and opposite sidewalls in the second direction D2 of the capping pattern 220. The first portion of the first gate insulation pattern 202 may further cover a sidewall in the first direction D1 of the end portion of the capping pattern 220.

The second portion of the first gate insulation pattern 202 may contact the first portion, and may extend in the first direction D1. The two parts of the first portion of the first gate insulation pattern 202 may extend in the first direction D1 on the opposite sidewalls of the first gate electrode 210 and the capping pattern 220 in the second direction D2, respectively, in a plan view. The two parts of the first portion of the first gate insulation pattern 202 may be merged with each other at the end portions of the first gate electrode 210 and the capping pattern 220. The merged portion of the first gate insulation pattern 202 may be connected to the second portion of the first gate insulation pattern 202 may further extend in the first direction D1.

In example embodiments, a width of the first portion of the first gate insulation pattern 202 on the sidewall of the first gate electrode 210 in the second direction D2 may be approximately half of a width of the second portion of the first gate insulation pattern 202 in the second direction D2. For example, each of the two parts of the first portion of the first gate insulation pattern 202 may have a first width WD1 in the second direction D2 in the first region I. The second portion of the first gate insulation pattern 202 may have a second width WD2 in the second direction D2. The first width WD1 may be less than the second width WD2. The first width WD1 may be approximately half of the second width WD2. For example, the first width WD1 may be less than 60% of the second width WD2.

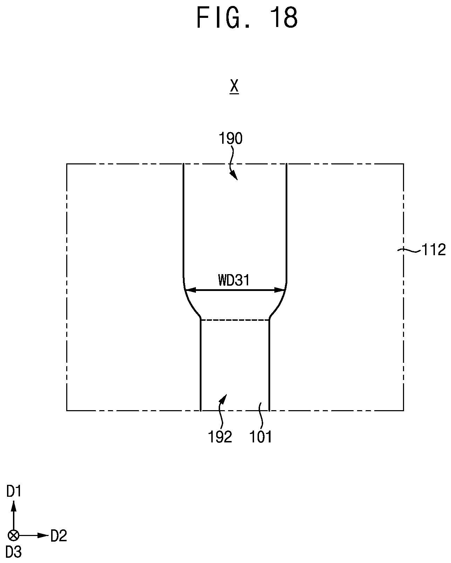

In example embodiments, referring to FIG. 1A together with FIG. 18, an outer sidewall in the second direction D2 of the first portion adjacent to the second portion of the first gate insulation pattern 202 may have a curved shape, e.g., a rounded shape, in a plan view. For example, referring to FIGS. 1A and 1B together with FIGS. 18, 22 and 23, the first portion of the first gate insulation pattern 202 may be arranged such that a distance WD3 between the curved (or rounded) outer sidewalls is gradually decreases, as it gets closer to the second portion of the first gate insulation pattern 202. The distance WD3 may correspond to the distance WD31 at the boundary of the first and second trenches 190 and 192 and/or the distance WD32 of the first gate insulation layer 200 within the first and second trenches 190 and 192 at the boundary of the first and second trenches 190 and 192 (see FIG. 23).

The capping pattern 220 may contact an inner sidewall of the first portion of the first gate insulation pattern 202 in the second direction D2. In example embodiments, a height level of an upper surface of the capping pattern 220 may be substantially the same as a height level of the upper surface of the first gate insulation pattern 202. In example embodiments, a cross-section of the first portion of the first gate insulation pattern 202 in the first direction D1 may have, e.g., a cup shape surrounding the first gate electrode 210 and the capping pattern 220, and a cross-section of the second portion of the first gate insulation pattern 202 in the first direction D1 may have, e.g., a bar shape. The term "cross-section in the first direction" may refer to a cross-section obtained by taking cutting along a vertical plane parallel to the first direction. Conversely, the term "cross-section taken along a line A-A‴ may refer to taking a cross-section by taking a cut along the line A-A'.

In example embodiments, the first gate electrode 210 may include a conductive material, e.g., a metal, a metal nitride, a metal silicide, etc., and each of the first gate insulation pattern 202 and the capping pattern 220 may include an insulating material, e.g., a silicon nitride, a silicon oxide, etc.

A plurality of channels 108 may be spaced apart from each other in each of the first and second directions D1 and D2 in the first region I. In example embodiments, the plurality of channels 108 may be spaced apart from each other in the second direction D2, and each of the plurality of channels 108 may contact an upper surface of the first conductive pattern 400 in the bit line 430 extending in the second direction D2.

The channel 108 may contact a lower portion of the outer sidewall in the second direction D2 of the first portion of the first gate insulation pattern 202. In an embodiment, an upper surface of the channel 108 may be higher than the upper surface of the first gate electrode 210.

In example embodiments, the channel 108 may include a semiconductor material, e.g., silicon (Si), germanium (Ge), silicon-germanium (Si-Ge), etc. Alternatively, the channel 108 may include at least one oxide semiconductor material, e.g., at least one of zinc tin oxide (ZTO), indium zinc oxide (IZO), zinc oxide (ZnOₓ), indium gallium zinc oxide (IGZO), indium gallium silicon oxide (IGSO), indium oxide (InOₓ, In₂O₃), tin oxide (SnO₂), titanium oxide (TiOₓ), zinc oxide nitride (ZnₓOyN_{z}), magnesium zincoxide (MgₓZn_{y}O_{z}), indium zinc oxide (InₓZn_{y}Oₐ), indium gallium zinc oxide (InₓGa_{y}Zn_{z}Oₐ), zirconium indium zinc oxide (ZrₓIn_{y}Zn_{z}Oₐ), hafnium indium zinc oxide (HfₓIn_{y}Zn_{z}Oₐ), tin indium zinc oxide (SnₓIn_{y}Zn_{z}Oₐ), aluminum tin indium zinc oxide (AlₓSn_{y}In_{z}ZnₐO_{d}), silicon indiumzinc oxide (SiₓIn_{y}Zn_{z}Oₐ), zinc tin oxide (ZnₓSn_{y}O_{z}), aluminum zinc tin oxide (AlₓZn_{y}Sn_{z}Oₐ), gallium zinc tin oxide (GaₓZn_{y}Sn_{z}Oₐ), zirconium zinc tin oxide (ZrₓZn_{y}Sn_{z}Oₐ) and indium gallium silicon oxide (InGaSiO).

Dummy channels 109 may be spaced apart from each other in the first direction D1 and the second direction D2 in the second region II. Each dummy channel 109 may be disposed on and contact the third insulating interlayer 600 in the second region II. In example embodiments, the dummy channels 109 may contact each of opposite sidewalls in the second direction D2 of the first and second portions of the first gate insulation pattern 202.

The dummy channel 109 may have substantially a constant width in the second direction D2, and thus each of an inner sidewall and an outer sidewall of the dummy channel 109 may have a curved shape, e.g., a rounded shape, corresponding to the shape of the first and second portions of the first gate insulation pattern 202, in a plan view.

The dummy channel 109 may include the same material as the channel 108. As used herein, the term "dummy" is used to refer to a component that has the same or similar structure and shape as other components but does not have a substantial function. A "dummy" element is patterned from the same layer(s) or material forming such non-dummy elements. "Dummy" elements in memory devices are not effective to cause transmission of data to external devices. In some instances, a "dummy" element may be electrically floated, or may be connected to various voltage sources but otherwise not provide the same functionality of the non-dummy element it represents. For example, dummy channel 109 may not connect and/or provide/receive an electrical signal to/from the bit line 430.

The second gate structure 265 may be disposed on the third insulating interlayer 600, the bit line 430 and the second insulation pattern 450, and may extend in the first direction D1. A plurality of second gate structures 265 may be spaced apart from each other in the second direction D2. In example embodiments, the second gate structure 265 may include a second gate insulation pattern 250 and a second gate electrode 260 sequentially stacked in the second direction D2 on each of opposite sides of the combination of the first gate structure 215, the channel 108, the dummy channel 109 and the first contact plug 280 in the second direction D2.

The second gate insulation pattern 250 may cover outer sidewalls in the second direction D2 and opposite sidewalls in the first direction D1 of the channel 108 and the dummy channel 109, and may also cover an outer sidewall in the second direction D2 of a portion of the first gate insulation pattern 202 which is not covered by the channel 108 and the dummy channel 109. The second gate electrode 260 may cover a portion of an outer sidewall of the second gate insulation pattern 250 in the second direction D2. For example, the first gate insulation pattern 202 and the second gate insulation pattern 250 may be partially in contact with each other such that the channel 108 and the dummy channel 109 may be disposed between the first gate insulation pattern 202 and the second gate insulation pattern 250.

The second gate insulation pattern 250 may not extend in a straight line in the first direction D1 but may extend in a curved line in the first direction D1 in a plan view. The second gate insulation pattern 250 may include a first portion contacting the sidewalls of the channel 108 and the dummy channel 109 and a second portion contacting the sidewall of the first gate insulation pattern 202. The first portion and the second portion of the second gate insulation pattern 250 may not be aligned with each other in the first direction D1 due to the channel 108 and the dummy channel 109. The second gate insulation pattern 250 may be arranged partially along a first straight line, and may be arranged partially along a second straight line. For example, the first portion of the second gate insulation pattern 250 may be arranged along the first straight line, and the second portion of the second gate insulation pattern 250 may be arranged along the second straight line. The first and second straight lines are different from each other and parallel to the first direction D1. The first and second straight lines are spaced apart from each other in the second direction D2. The first and second portions may be disposed alternately and repeatedly in the first direction D1, so that the second gate insulation pattern 250 may extend in a curved line. The second gate insulation pattern 250 may include curved portions, at connections between the first and second portions. The second gate insulation pattern 250 may extend along a path with repeated curves.

In a plan view, the second gate electrode 260 may extend in the first direction D1 which is parallel to the second gate insulation pattern 250, following the shape of the path of second gate insulation pattern 250. For example, the second gate electrode 260 may extend in the first direction D1 similarly to the second gate insulation pattern 250, and may not extend in a straight line in the first direction D1, and may extend in a curved line. The second gate electrode 260 may also include a first portion on the first portion of the second gate insulation pattern 250 and a second portion on the second portion of the second gate insulation pattern 250. The first portion and the second portion of the second gate electrode 260 may not be aligned with each other in the first direction D1 due to the second gate insulation pattern 250, and the first and second portions may be disposed alternately and repeatedly in the first direction D1, so that the second gate electrode 260 may extend in a curved line in the first direction D1. The second gate electrode 260 may include curved portions, at connections between the first and second portions.

In example embodiments, the second gate electrode 260 may include a conductive material, e.g., a metal, a metal nitride, a metal silicide, etc., and the second gate insulation pattern 250 may include an insulating material, e.g., a silicon nitride, a silicon oxide, etc.

The first insulation pattern 360 may be disposed on the third insulating interlayer 600, the bit line 430 and the second insulation pattern 450, and may contact a lower portion of the outer sidewall of the second gate insulation pattern 250 in the second direction D2 and a lower surface of the second gate electrode 260. The second gate electrode 260 may be spaced apart from the bit line 430 in the third direction D3 by the first insulation pattern 360.

In example embodiments, the first insulation pattern 360 may include an insulating material, e.g., silicon oxide, silicon nitride, etc.

The first contact plug 280 may be disposed on the channel 108 and may contact the upper surface thereof. In example embodiments, the first contact plug 280 may contact an upper portion of the outer sidewall of the first gate insulation pattern 202 in the second direction D2 and an upper portion of an inner sidewall of the second gate insulation pattern 250 in the second direction D2.

In example embodiments, a plurality of first contact plugs 280 may be spaced apart from each other in each of the first and second directions D1 and D2 in the first region **I,** and may be arranged in, e.g., a lattice shape or a honeycomb shape in a plan view.

In example embodiments, the first contact plug 280 may include polysilicon, or a conductive material, e.g., a metal, a metal nitride, a metal silicide, etc. In other embodiments, the first contact plug 280 may have a double-layered structure in which an undoped polysilicon pattern and a doped polysilicon pattern are sequentially stacked.

The gate division pattern 270 may be disposed on the third insulating interlayer 600, the bit line 430 and the second insulation pattern 450, and may contact upper surfaces thereof.

In example embodiments, the gate division pattern 270 may include a lower portion and an upper portion. The lower portion of the gate division pattern 270 may contact an outer sidewall of the second gate electrode 260 in the second direction D2 and an outer sidewall of the first insulation pattern 360 in the second direction D2. The upper portion of the gate division pattern 270 may be disposed on and contact the lower portion, and may contact an upper portion of the outer sidewall of the second gate insulation pattern 250 in the second direction D2 and an upper surface of the second gate electrode 260. In example embodiments, a width of the upper portion of the gate division pattern 270 in the second direction D2 may be larger than a width of the lower portion of the gate division pattern 270 in the second direction D2.

In example embodiments, the gate division pattern 270 may extend in the first direction D1, and a plurality of gate division patterns 270 may be spaced apart from each other in the second direction D2. Each of the plurality of gate division patterns 270 may be disposed between ones of the second gate structures 265 neighboring in the second direction D2, and may separate the ones of the second gate structures 265 from each other in the second direction D2.

In example embodiments, the gate division pattern 270 may include an insulating material, e.g., an oxide such as silicon oxide, or a nitride such as silicon nitride.

The landing pad 300 may extend through the first insulating interlayer 290, and may contact an upper surface of the first contact plug 280. In example embodiments, a plurality of landing pads 300 may be arranged so as to be spaced apart from each other in each of the first and second directions D1 and D2, corresponding to the first contact plugs 280, respectively. The plurality of landing pads 300 may be arranged in, e.g., a lattice shape or a honeycomb shape in a plan view. FIG. 1A shows that the landing pad 300 has a rectangular shape in a plan view, but the inventive concept is not limited thereto, and the landing pad 300 may have other shapes, e.g., a shape of, a circle, an oval, a square with rounded corners, etc., in a plan view. The landing pad 300 may include a conductor, e.g., a metal, a metal nitride, a metal silicide, etc.

The capacitor structure may include a capacitor 335 and an upper plate electrode 340. The capacitor 335 may include a first capacitor electrode 310, a dielectric pattern 320 and a second capacitor electrode 330.

In example embodiments, a plurality of first capacitor electrodes 310 may be spaced apart from each other in each of the first and second directions D1 and D2, and may contact respective upper surfaces of corresponding ones of landing pads 300. The dielectric pattern 320 may be disposed on upper surfaces and sidewalls of the first capacitor electrodes 310 and an upper surface of the first insulating interlayer 290. The second capacitor electrode 330 may be disposed on the dielectric pattern 320.

The first capacitor electrode 310 may include a conductor, e.g., a metal, a metal nitride, a metal silicide, etc., the dielectric pattern 320 may include a dielectric material, e.g., a metal oxide, and the second capacitor electrode 330 may include a conductor, e.g., a metal, a metal nitride, a metal silicide, silicon-germanium doped with impurities, etc.

The upper plate electrode 340 may be disposed on the second capacitor electrode 330 and may include a conductor, e.g., silicon-germanium doped with impurities.

The second insulating interlayer 350 may be disposed on the first insulating interlayer 290 and may cover the upper plate electrode 340 in the first region I. The second insulating interlayer 350 may cover the first insulating interlayer 290 in the second region II.

Each of the first and second insulating interlayers 290 and 350 may include an insulating material, e.g., silicon oxide (SiO₂), silicon nitride (SiN), a low-k material, etc.

The second contact plug 610 may extend through the first and second insulating interlayers 290 and 350 and the capping pattern 220 in the second region II and may contact the upper surface of the first gate electrode 210. In example embodiments, the second contact plug 610 may contact the end portion of the first gate electrode 210 in the first direction D1. In an embodiment, the second contact plug 610 may also extend through a portion of the first gate insulation pattern 202 adjacent to the capping pattern 220.

The third contact plug 620 may extend through the first and second insulating interlayers 290 and 350 and the upper portion of the gate division pattern 270 in the second region II and may contact the upper surface of the second gate electrode 260. In an embodiment, the third contact plug 620 may also extend through a portion of the second gate insulation pattern 250 adjacent to the first gate electrode 210.

In example embodiments, a plurality of second contact plugs 610 may be spaced apart from each other in the second direction D2 by a first distance, and a plurality of third contact plugs 620 may be spaced apart from each other in the second direction D2 by a second distance smaller than the first distance.

The components of the semiconductor device may have a symmetrical arrangement. For example, a pair of the first gate structures 215, a pair of the second gate structures 265, a pair of the channels 108, a pair of the dummy channels 109, a pair of the gate division patterns 270, a pair of the landing pads 300 and/or a pair of the capacitor structures may be symmetrically arranged (e.g. along an axis of symmetry that runs parallel to the first direction D1).

In some embodiments, in a plan view, the components of the semiconductor device may be arranged symmetrically, with respect to a line which is parallel to the first direction D1 and passes through the end portion or the central portion CTP of the protruding shape of the capping pattern 220 (or the first gate electrode 210) in a plan view.

In some embodiments, the components of the semiconductor device may be arranged symmetrically, with respect to a plane which is parallel to the first and third direction D1 and D3 and passes through the end portion or the central portion CTP. For example, the first gate structure 215, a pair of the second gate structures 265, a pair of the channels 108, a pair of the dummy channels 109, a pair of the gate division patterns 270, a pair of the landing pads 300 and/or capacitor structures may be arranged symmetrically with respect to the plane.

In the semiconductor device, electrical current may flow in the third direction D3, e.g., in a vertical direction, in the channel 108. Accordingly, the semiconductor device may include a vertical channel transistor (VCT) having a vertical channel. The second gate electrode 260 may serve as a front electrode or a word line of the semiconductor device or the VCT, and the first gate electrode 210 may serve as a back gate electrode of the semiconductor device or the VCT.

In some embodiments, the semiconductor device may be a semiconductor memory device including a plurality of memory cells. Each of the memory cells may be a one-transistor one-capacitor (1T1C) memory cell including a transistor and a data storage element, which may be the VCT and the capacitor described above, respectively.

For example, the data storage element may be any kind of resistor including an MTJ (magnetic tunnel junction), a ferroelectric tunnel junction (FTJ) and combinations thereof used in a one-transistor one-resistor (1T1R) memory cell, which is a type of memory comprising one resistor and one transistor. For example, the combination of the data storage element and the VCT may a memory cell of a selected one from the group consisting of data storage elements (or patterns) of a phase-change memory (PCM, PRAM, PCRAM, PCRAM), a resistive memory (RRAM), a magnitoresistive memory (MRAM), a polymer memory (PRAM), a molecular memory, a ferroelectric memory (FeRAM), an ionic memory (PMC), a memristive memory, a spin memory, an oxide memory (such as ReRAM and 0xRAM), a conductive bridging random access memory (CBRAM), and combinations thereof.

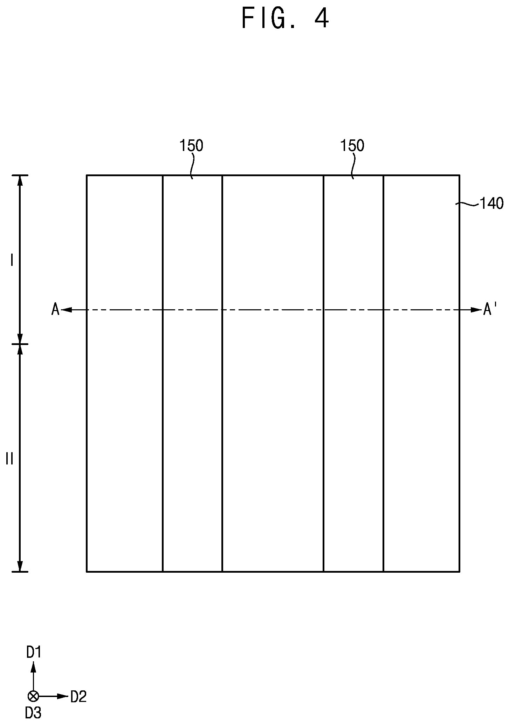

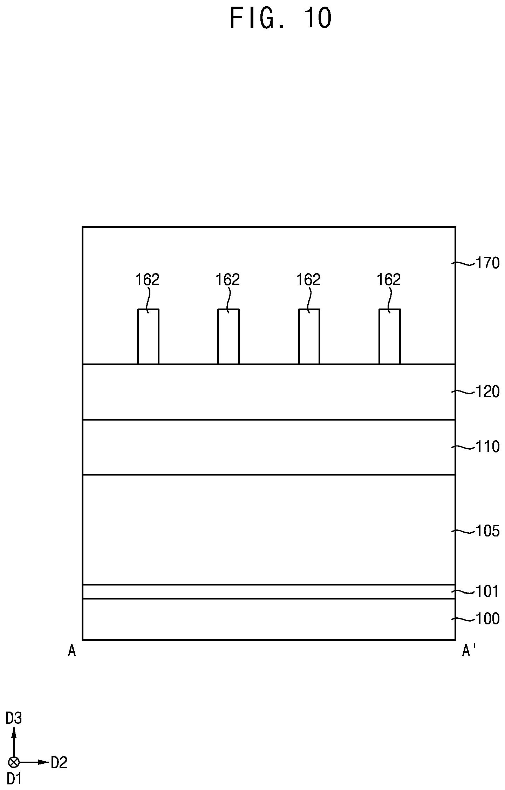

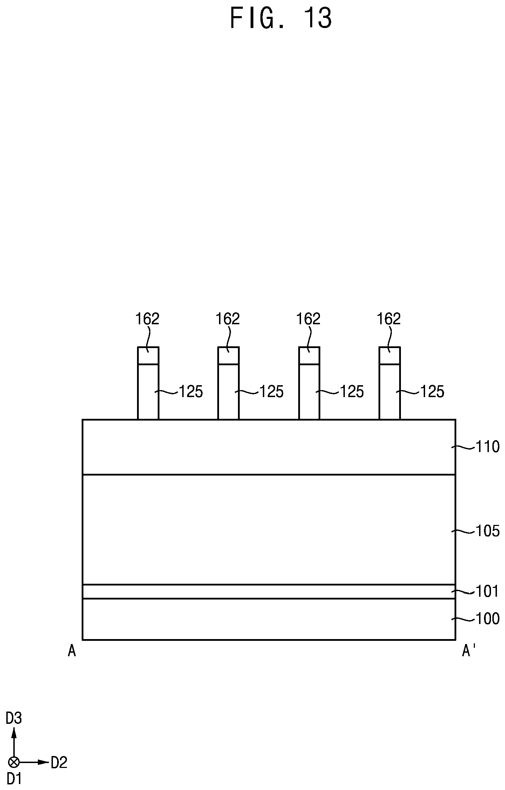

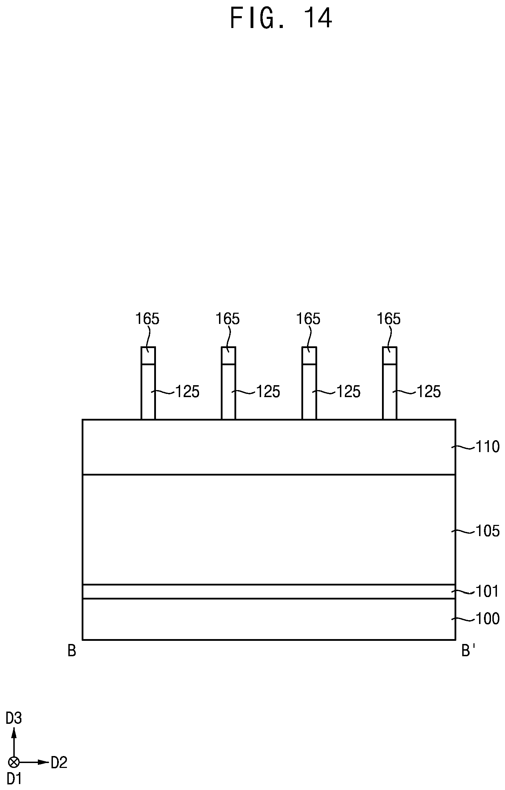

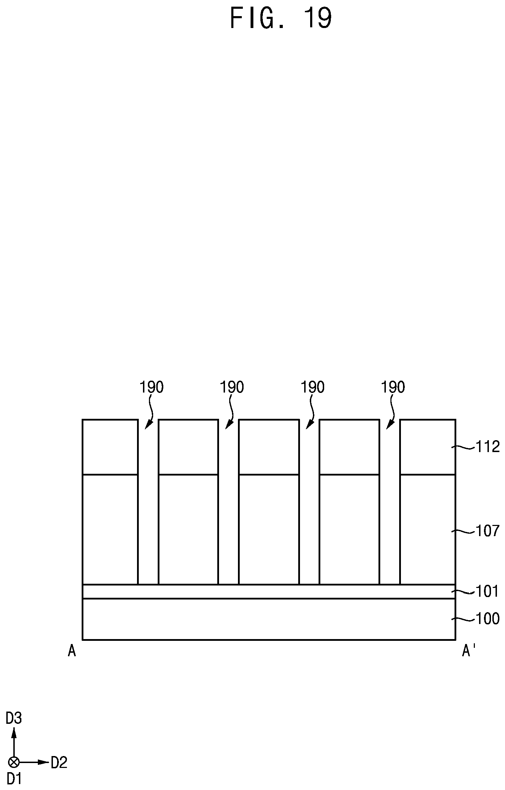

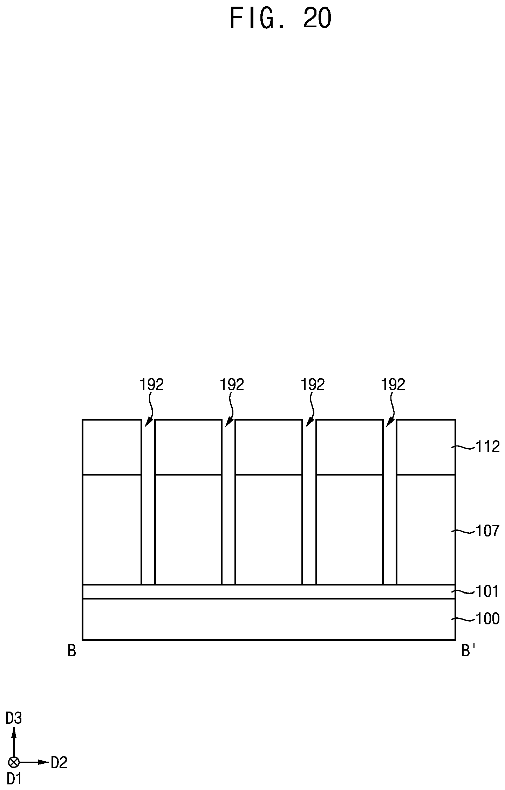

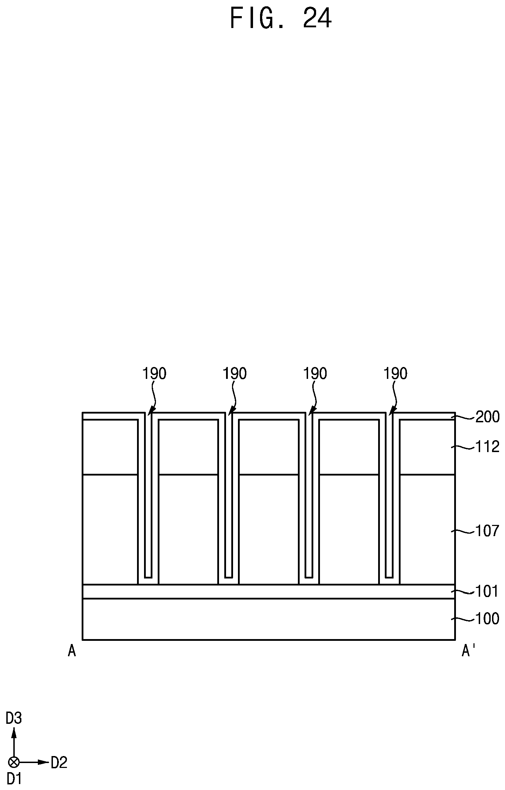

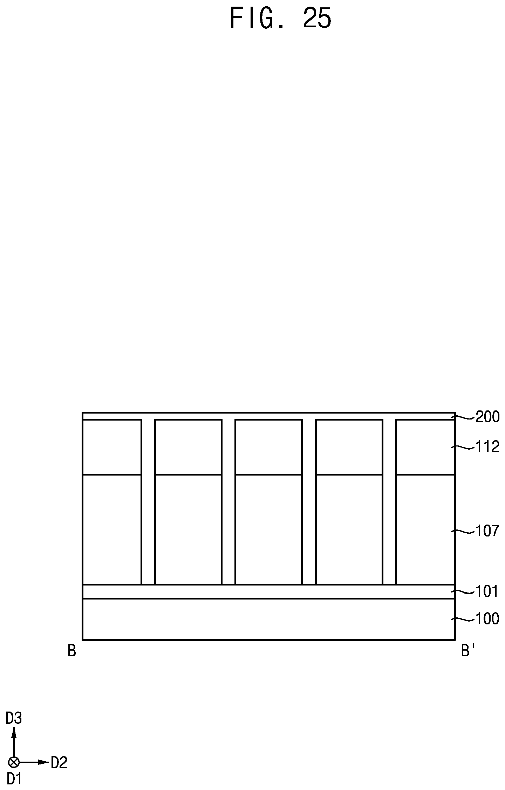

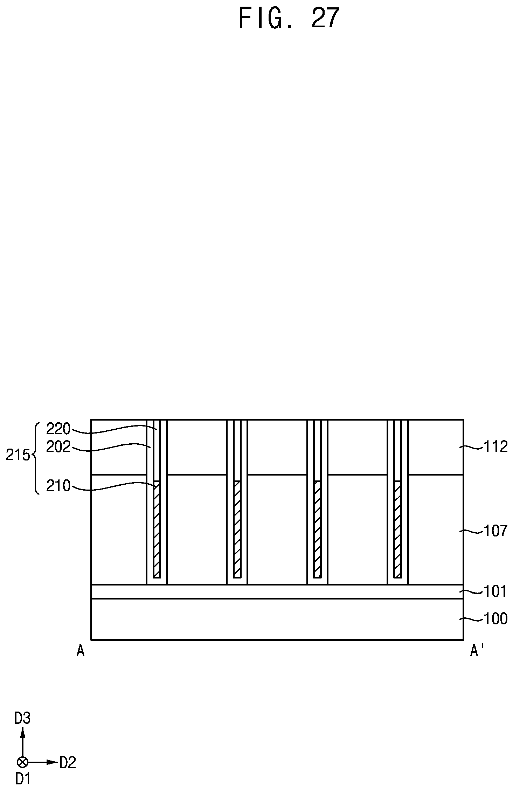

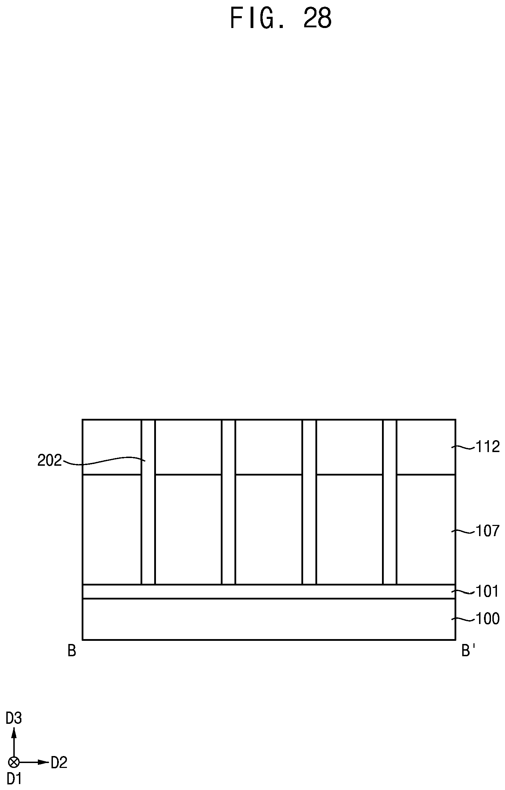

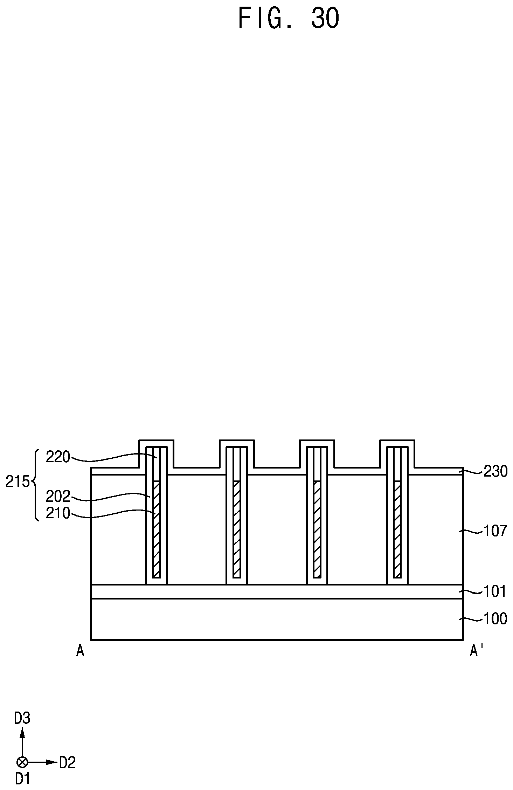

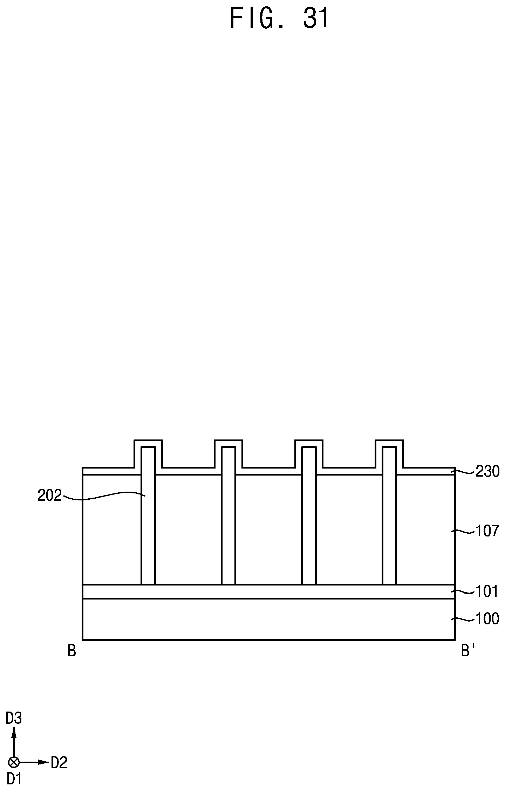

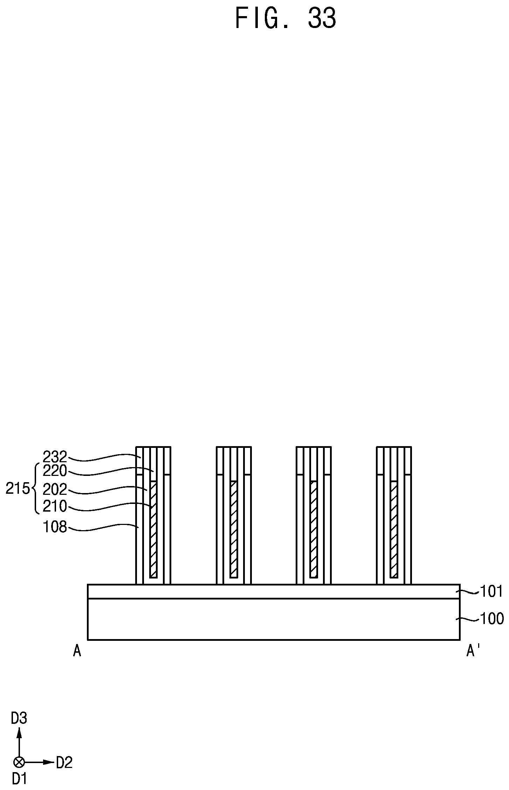

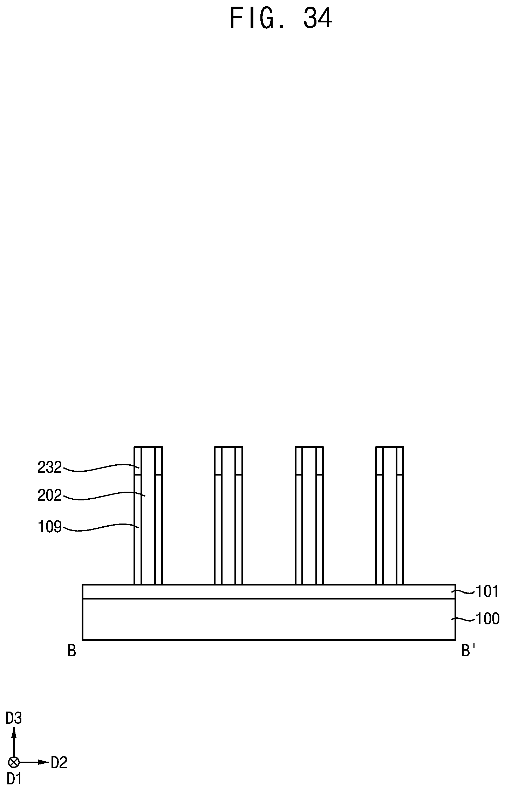

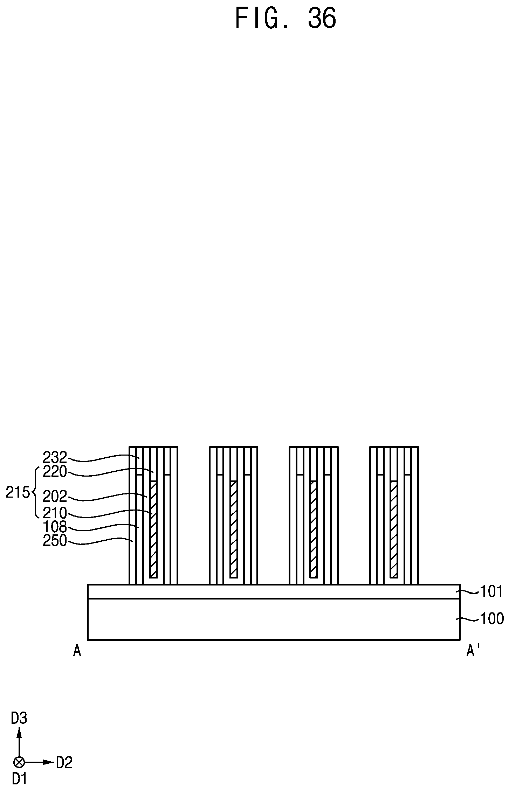

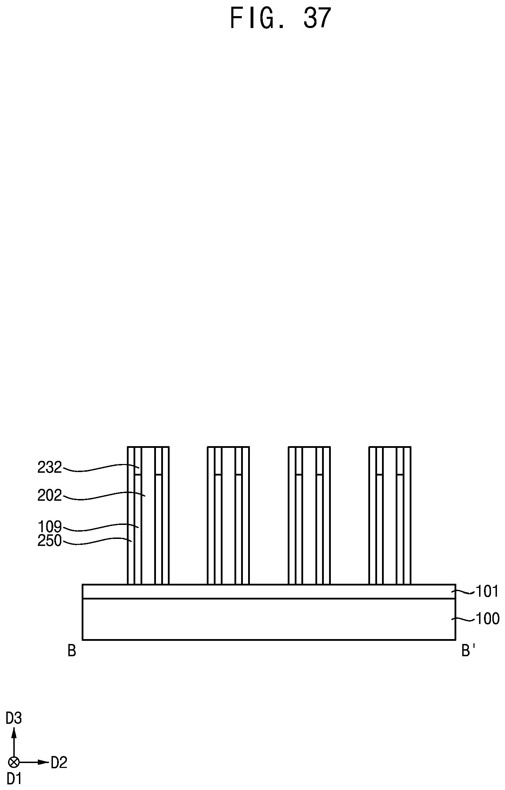

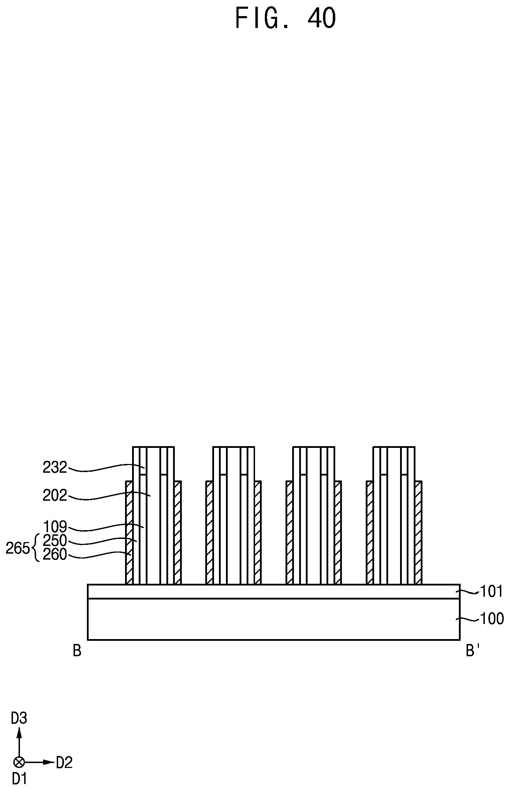

As illustrated below with reference to FIGS. 4 to 48, in the semiconductor device, the first and second portions of the first gate insulation pattern 202 may be aligned with each other in the first direction D1 and may not be misaligned with each other in the second direction D2, and thus misalignment and electrical short or leakage current caused by the misalignment may not generated between the first gate electrode 210 disposed in a space surrounded by the first portion of the first gate insulation pattern 202 and the second contact plug 610 disposed on the first gate electrode 210, and between the second gate electrode 260 spaced apart from the first gate electrode 210 in the second direction D2 and the third contact plug 620 disposed on the second gate electrode 260. For example, the first and second portions of the first gate insulation pattern 202 may be formed substantially simultaneously, using the same or similar methods (e.g., formed of substantially the same material at the same process steps), allowing the first and second portions of the first gate insulation pattern 202 to be connected coherently in a predetermined, orderly, and/or robotic manner (e.g., without any misalignment between them). Thus, any malfunctions caused by the first gate insulation pattern 202 and its related components may be minimized. For example, the semiconductor device including the first and second gate electrodes 210 and 260 and the third contact plug 620 may have improved electrical performance.

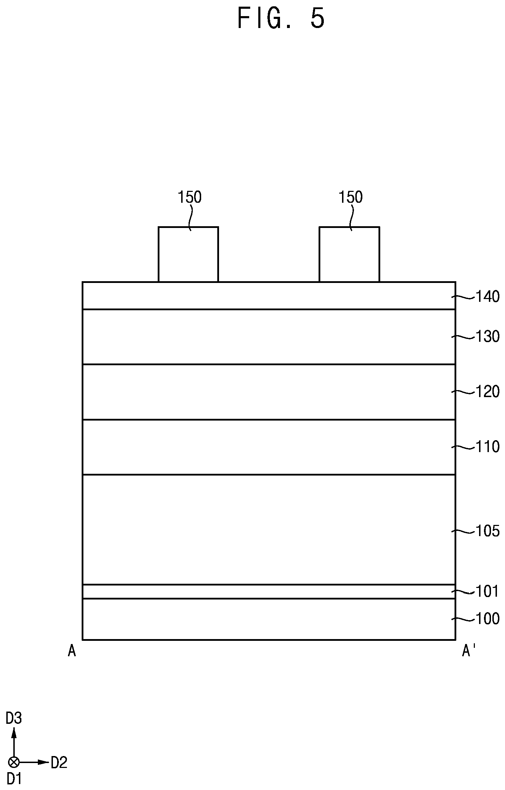

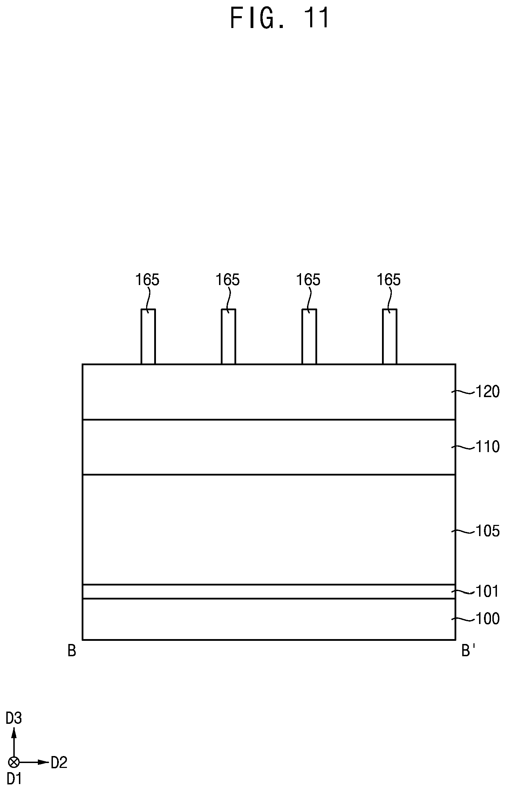

FIGS. 4 to 48 are plan views and cross-sectional views illustrating a method of manufacturing a semiconductor device in accordance with example embodiments. Specifically, FIGS. 4, 7, 9, 12, 17, 21, 26, 29, 32, 35, 38, 41, 45 and 47 are the plan views, FIGS. 18, 22 and 23 are enlarged cross-sectional views of X region of corresponding plan views, respectively, FIGS. 5, 6, 8, 10, 13, 15, 19, 24, 27, 30, 33, 36, 39, 42, 43, 46 and 48 are cross-sectional views taken along line A-A' of corresponding plan views, respectively, and FIGS. 11, 14, 16, 20, 25, 28, 31, 34, 37, 40 and 44 are cross-sectional views taken along line B-B' of corresponding plan views, respectively.

Referring to FIGS. 4 and 5, first to fourth mask layers 110, 120, 130 and 140 may be sequentially formed on a substrate in first and second regions I and II.

The substrate may be, e.g., a silicon-on-insulator (SOI) substrate or a germanium-on-insulator (GOI) substrate, and thus may include a first bulk substrate 100, a buried insulation layer 101 and a second bulk substrate 105 sequentially stacked along the third direction D3. Each of the first and second bulk substrates 100 and 105 may include a semiconductor material, e.g., silicon or germanium, and the buried insulation layer 101 may include an insulating material, e.g., silicon oxide.

Hereinafter, the first and second regions I and II may refer not only to an inside of the substrate (the substrate itself) but also to a space above and below the substrate.

The first mask layer 110 may include a material having an etch selectivity with respect to the second bulk substrate 105, e.g., silicon nitride (SiN), the second mask layer 120 may include, e.g., polysilicon, the third mask layer 130 may include, e.g., spin-on hardmask (SOH), and the fourth mask layer 140 may include, e.g., silicon oxynitride (SiON).

A photoresist layer may be formed on the fourth mask layer 140, and a photo process may be performed on the photoresist layer to form a photoresist pattern 150. In example embodiments, the photoresist pattern 150 may extend in the first direction D1 and a plurality of photoresist patterns 150 may be spaced apart from each other in the second direction D2.

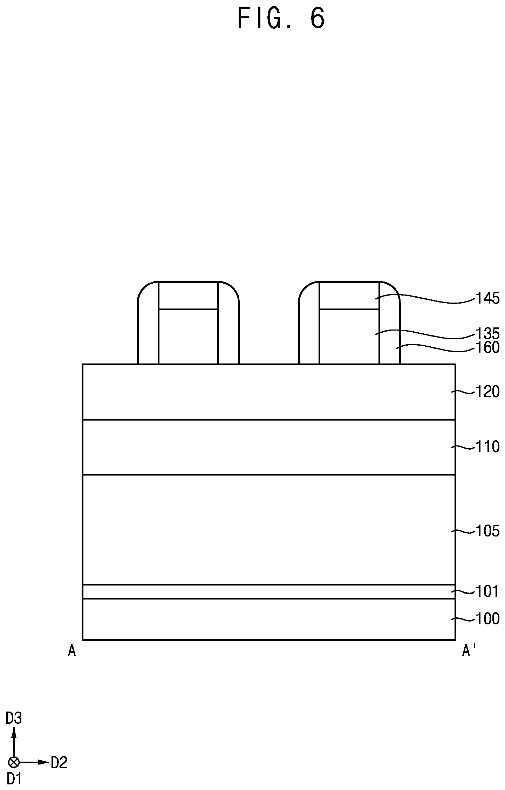

Referring to FIG. 6, an etching process using the photoresist pattern 150 as an etching mask may be performed so that the fourth mask layer 140 and the third mask layer 130 may be etched to form a fourth mask pattern 145 and a third mask pattern 135, respectively, and thus a portion of an upper surface of the second mask layer 120 may be exposed.

A spacer layer may be formed on the exposed portion of the upper surface of the second mask layer 120, opposite sidewalls of the third mask pattern 135 and the fourth mask pattern 145 in the second direction D2 and an upper surface of the fourth mask pattern 145, and an anisotropic etching process may be performed on the spacer layer.

Thus, a spacer 160 extending in the first direction D1 may be formed on each of the opposite sidewalls of the third mask pattern 135 and the fourth mask pattern 145 in the second direction D2.

In example embodiments, the spacer 160 may include a material having an etch selectivity with respect to the second mask layer 120, e.g., silicon oxide.

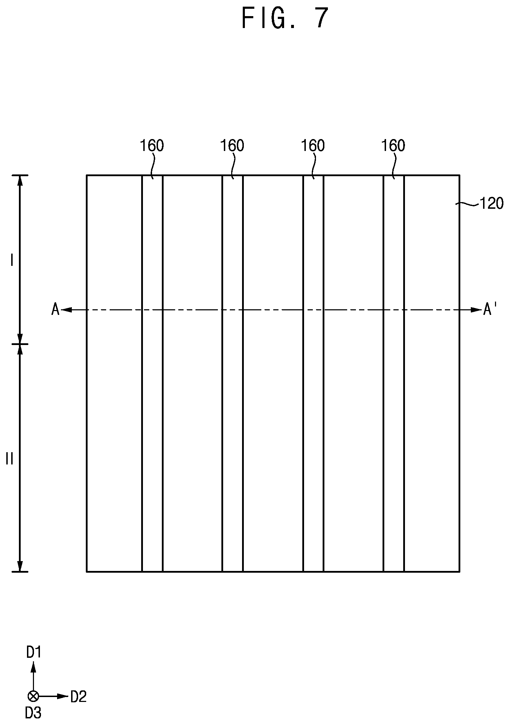

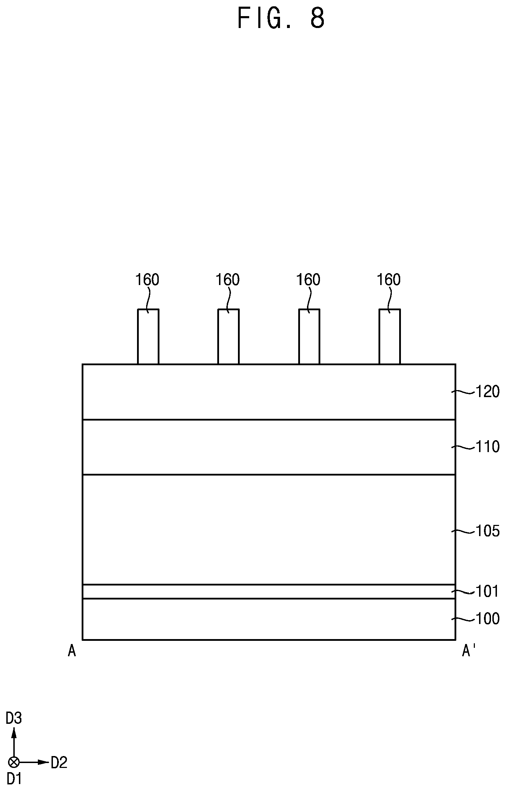

Referring to FIGS. 7 and 8, a planarization process, e.g., a chemical mechanical polishing (CMP) process, may be performed on the spacer 160 and the fourth mask pattern 145 until an upper surface of the third mask pattern 135 is exposed, and an etching process may be performed on the third mask pattern 135 to remove the third mask pattern 135.

Thus, a portion of an upper surface of the second mask layer 120 between ones of the spacers 160 adjacent to each other in the second direction D2 may be exposed.

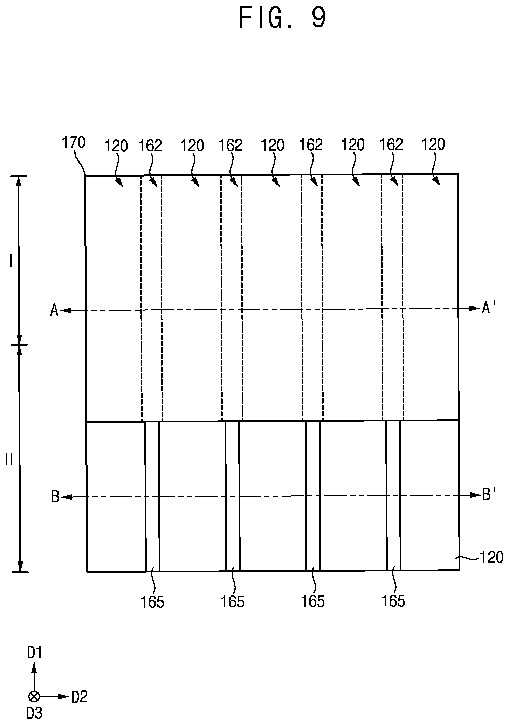

Referring to FIGS. 9 to 11, a fifth mask pattern 170 may be formed on the first region I of the substrate and a portion of the second region II of the substrate neighboring the first region I to cover the second mask layer 120 and the spacer 160, an etching process may be performed on a portion of the spacer 160 on the portion of second region II of the substrate, which is not covered by the fifth mask pattern 170, and thus, a volume of the portion of the spacer 160, particularly, a width of the portion of the spacer 160 in the second direction D2 may be reduced.

Hereinafter, a portion of the spacer 160, which is covered by the fifth mask pattern 170, may be referred to as a first spacer 162, and a portion of the spacer 160, which is not covered by the fifth mask pattern 170, may be referred to as a second spacer 165. In example embodiments, a width of the first spacer 162 in the second direction D2 may be larger than a width of the second spacer 165 in the second direction D2.

In example embodiments, the etching process for reducing the width of the spacers may include, e.g., a wet etching process, and the wet etching process may include a cleaning process.

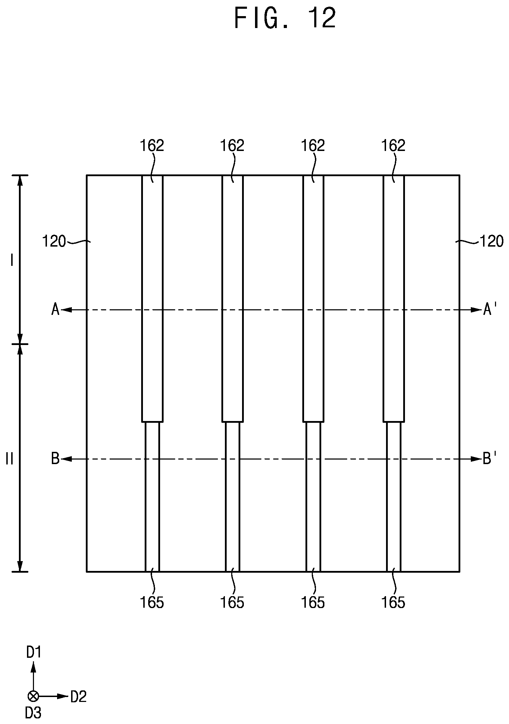

Referring to FIGS. 12 to 14, the fifth mask pattern 170 may be removed, and an etching process using the first and second spacers 162 and 165 as an etching mask may be performed so that the second mask layer 120 may be patterned.

By the etching process, a portion of the second mask layer 120 under each of the first and second spacers 162 and 165 may be divided into a plurality of second mask patterns 125, each of which may extend in the first direction D1, spaced apart from each other in the second direction D2.

A width in the second direction D2 of a portion of the second mask pattern 125 under the first spacer 162 may be substantially the same as a width of the first spacer 162 in the second direction D2, and a width in the second direction D2 of a portion the second mask pattern 125 under the second spacer 165 may be substantially the same as a width of the second spacer 165 in the second direction D2. Thus, the width in the second direction D2 of the portion of the second mask pattern 125 under the first spacer 162 may be greater than the width in the second direction D2 of the portion of the second mask pattern 125 under the second spacer 165.

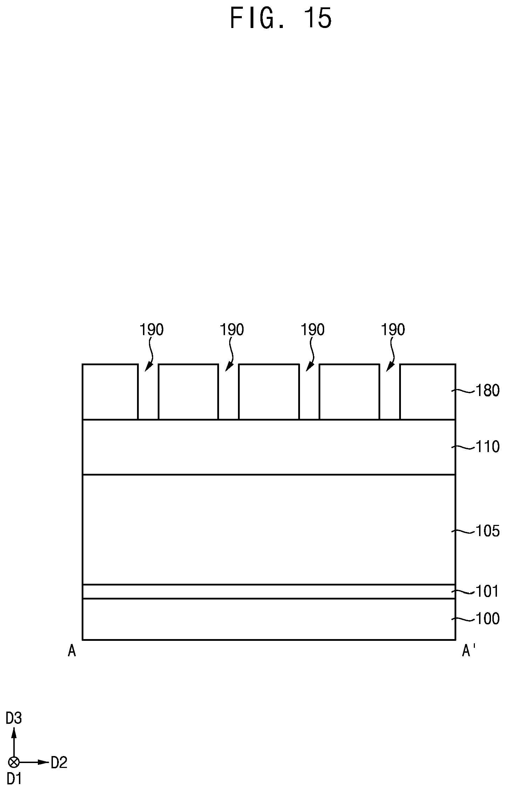

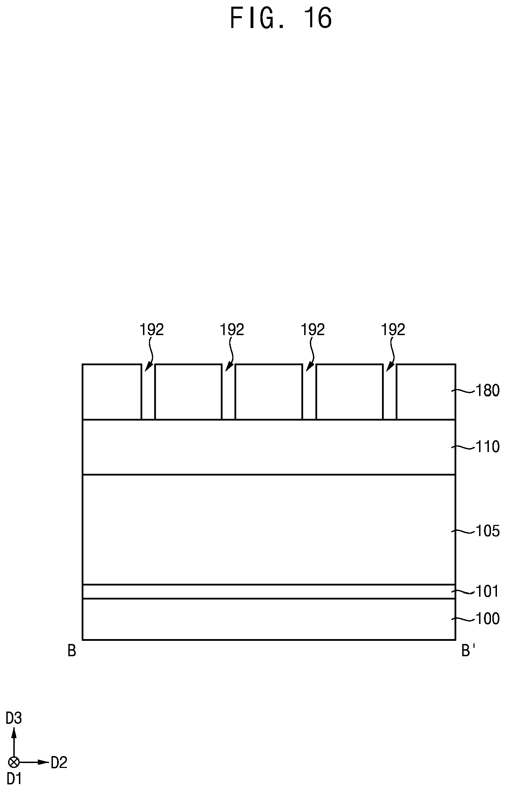

Referring to FIGS. 15 and 16, a sixth mask layer may be formed on the first mask layer 110 to cover the second mask pattern 125, the first spacer 162 and the second spacer 165 to a sufficient height, and a planarization process, e.g., a chemical mechanical polishing (CMP) process may be performed on the sixth mask layer and the first and second spacers 162 and 165 until an upper surface of the second mask pattern 125 is exposed.

Thus, the sixth mask layer may be divided into a plurality of sixth mask patterns 180, each of which may extend in the first direction D1, spaced apart from each other in the second direction D2.

The second mask pattern 125 may be removed by, e.g., a wet etching process to form first and second trenches 190 and 192 on the first and second regions I and II, respectively, of the substrate. For example, the first trenches 190 may be formed in the first region I and in a portion of the second region II neighboring the first region I such that the first and second trenches 190 and 192 may be disposed in corresponding areas where first and second spacers 162 and 165 have been removed.

In example embodiments, each of the first and second trenches 190 and 192 may extend in the first direction D1, and a width of the first trench 190 in the second direction D2 may be greater than a width of the second trench 192 in the second direction D2. Thus, the sixth mask pattern 180 may have a staircase shape in a plan view at the boundary where the first and second trenches 190 are connected.

The sixth mask pattern 180 may include, e.g., silicon oxide.

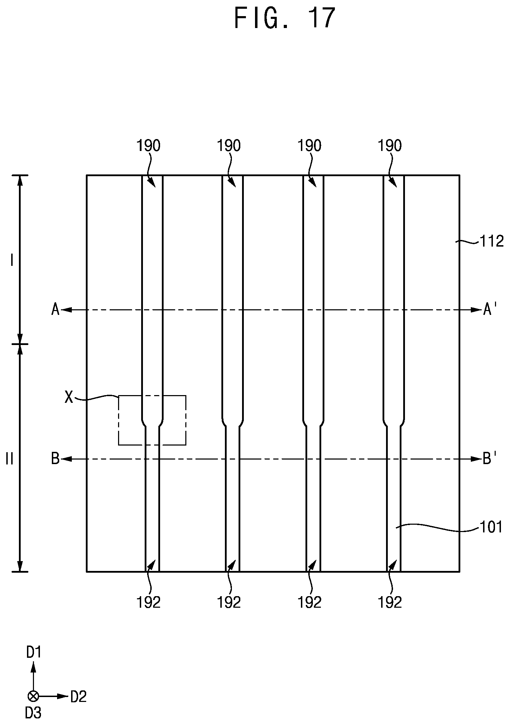

Referring to FIGS. 17 to 20, the first mask layer 110 and the second bulk substrate 105 may be etched by an etching process using the sixth mask pattern 180 as an etching mask so that the first mask layer 110 and the second bulk substrate 105 may be transformed into a first mask pattern 112 and a preliminary channel pattern 107, respectively.

The etching process may be performed using the buried insulation layer 101 as an etch stop layer, and thus, each of the first and second trenches 190 and 192 may extend downward in the third direction D3 to expose an upper surface of the buried insulation layer 101.

During the etching process, a portion of the first trench 190 adjacent to the second trench 192 may not be partially enlarged downward in the third direction D3. A width of portions of the second trench 192 and the first trench 190 adjacent to each other in the first direction D1 may change rapidly in the second direction D2, so that portions of the first mask pattern 112 and the preliminary channel pattern 107 under the portions of the second trench 192 and the first trench 190 may be etched in a shape with rounded corners instead of being etched in a shape of the sixth mask pattern 180. Thus, a boundary portion of the first trench 190 and the second trench 192 may have a curved shape, e.g., a rounded shape instead of a step shape in a plan view.

For example, during the etching process, the shape and size of the sixth mask pattern 180 may not be transferred onto the underlying material (i.e., the first mask layer 110 and the second bulk substrate 105) as is, but may undergo deformation. For example, though the sixth mask pattern 180 may have a step shape (or a staircase shape) including sharp corners as described above, the step shape of the sixth mask pattern 180 may not be exactly transferred onto the underlying material. The transferred shape onto the underlying material may not be sharp, but rounded. In addition, at the boundary portion of the first trench 190 and the second trench 192, the distance WD31 may be gradually changed as described above. The distance WD31 may be a distance between outer walls of the first and second trenches 190 and 192.

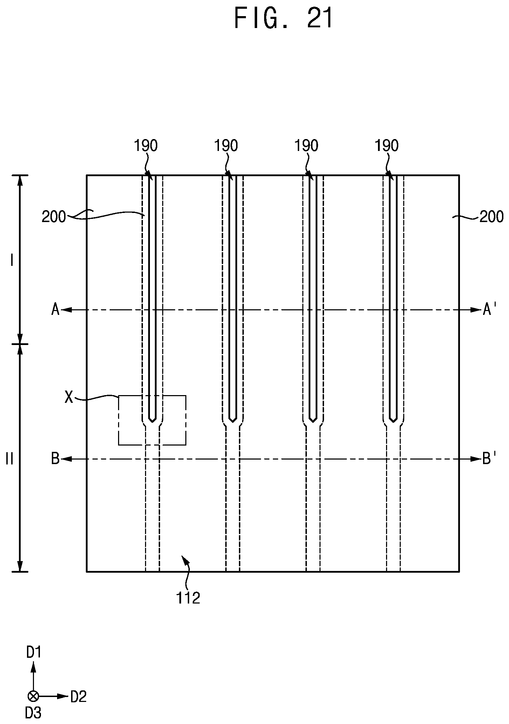

Referring to FIGS. 21 to 25, a deposition process may be performed on an inner wall of each of the first trench 190 and the second trench 192 and on the first mask pattern 112 to conformally form a first gate insulation layer 200.

During the deposition process, the first gate insulation layer 200 may not fill an entire portion of the first trench 190 having a relatively large width but may be conformally formed only on the inner wall of the first trench 190, while the first gate insulation layer 200 may fill an entire portion of the second trench 192 having a relatively small width. For instance, the thickness of the first gate insulation layer 200 may be greater than or equal to half the width of the second trench 192, but less than half the width of the first trench 190. The distance WD32 may be gradually changed as described above (e.g. in accordance with the change in the distance WD31). The distance WD32 may be a distance between outer walls of the first gate insulation layer 200 within the first and second trenches 190 and 192.

The deposition process may include, e.g., a physical vapor deposition (PVD) process, a chemical vapor deposition (CVD) process or an atomic layer deposition (ALD) process.

In an embodiment, as shown in FIG. 22, a central portion of an end portion of the first trench 190 in the first direction D1 may have, e.g., a pointed shape in a plan view. In another embodiment, as shown in FIG. 23, the central portion of the end portion of the first trench 190 in the first direction D1 may have, e.g., a curved shape, such as a semicircle, in a plan view.

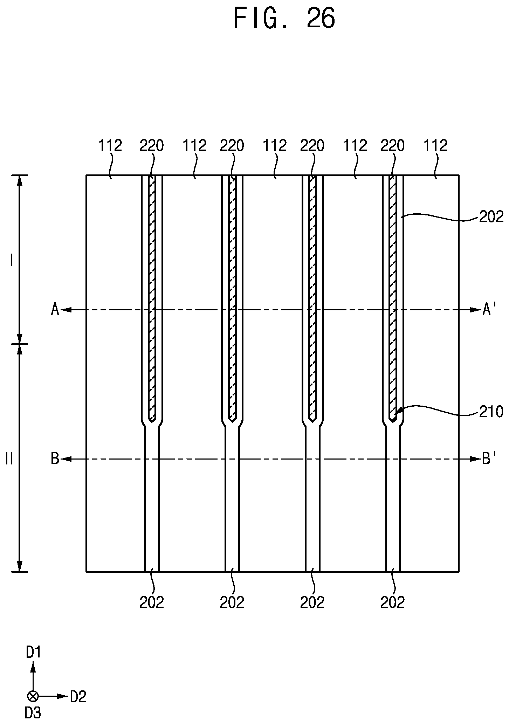

Referring to FIGS. 26 to 28, a first gate electrode 210 may be formed in a lower portion of the first trench 190, a capping pattern 220 may be formed in an upper portion of the first trench 190, and the first gate insulation layer 200 may be transformed into a first gate insulation pattern 202.

Specifically, a first gate electrode layer filling the first trench 190 may be formed on the first gate insulation layer 200, a planarization process, e.g., a chemical mechanical polishing (CMP) process may be performed on the first gate electrode layer and the first gate insulation layer 200 until an upper surface of the first mask pattern 112 is exposed, and an upper portion of the first gate electrode layer may be further removed by an etching process to form the first gate electrode 210, and the first gate insulation layer 200 may be transformed into the first gate insulation pattern 202 on the inner wall of the first trench 190 and in the second trench 192.

After the etching process, a height level of an upper surface of the first gate electrode 210 may be lower than a height level of an upper surface of the preliminary channel pattern 107.

A capping layer filling a remaining portion of the first trench 190 may be formed on the first gate electrode 210, the first gate insulation pattern 202 and the first mask pattern 112, and a planarization process, e.g., a chemical mechanical polishing (CMP) process may be performed on the capping layer until the upper surface of the first mask pattern 112 is exposed to form a capping pattern 220 on the first gate electrode 210.

The first gate electrode 210, the first gate insulation pattern 202 and the capping pattern 220 may collectively form a first gate structure 215.

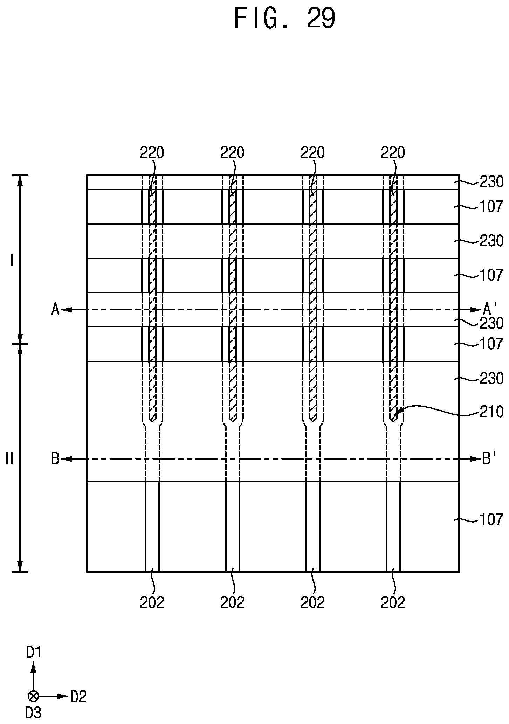

Referring to FIGS. 29 to 31, the first mask pattern 112 may be removed to expose the upper surface of the preliminary channel pattern 107, an upper sidewall and an upper surface of the first gate insulation pattern 202 and an upper surface of the capping pattern 220, and a seventh mask pattern 230 may be conformally formed to partially cover the upper surface of the preliminary channel pattern 107, the upper sidewall and the upper surface of the first gate insulation pattern 202 and the upper surface of the capping pattern 220.

In example embodiments, the seventh mask pattern 230 may extend in the second direction D2 and a plurality of seventh mask patterns 230 may be spaced apart from each other in the first direction D1. A width of the seventh mask pattern 230 on the first region I of the first bulk substrate 100 in the first direction D1 may be smaller than a width of the seventh mask pattern 230 on the second region II of the first bulk substrate 100 in the first direction D1.

However, in an embodiment, the seventh mask pattern 230 may not be formed on the second region II of the first bulk substrate 100.

In example embodiments, the seventh mask pattern 230 may include an insulating material, e.g., silicon oxide or silicon nitride.

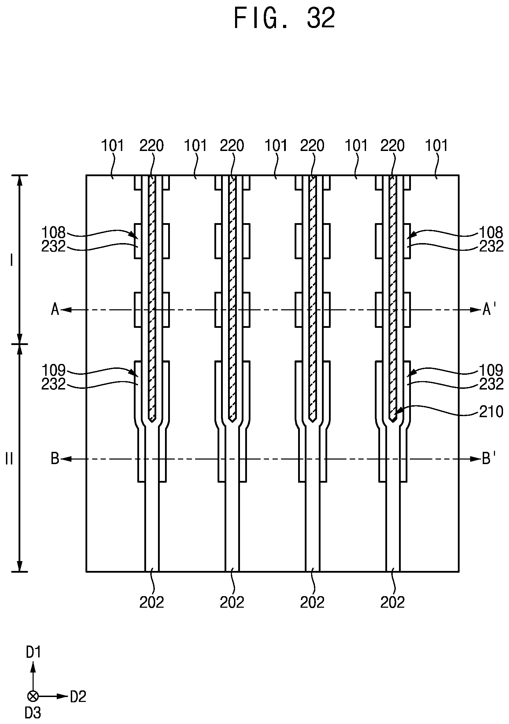

Referring to FIGS. 32 to 34, a plurality of channels 108 spaced apart from each other in the first direction D1 may be formed along an outer sidewall of the first gate insulation pattern 202 on the first region I of the first bulk substrate 100.

Specifically, a first anisotropic etching process may be performed on the seventh mask pattern 230 to form a third spacer 232 on an upper portion of the outer sidewall of the first gate insulation pattern 202 and a portion of the upper surface of the preliminary channel pattern 107, and a second anisotropic etching process may be performed on the preliminary channel pattern 107 using the third spacer 232 as an etching mask. Thus, the preliminary channel pattern 107 may be transformed into channels 108 covering each of opposite lower sidewalls of the first gate insulation pattern 202 in the second direction D2.

As a plurality of seventh mask patterns 230 is formed to be spaced apart from each other in the first direction D1 on the first region I of the first bulk substrate 100, a plurality of channels 108 may be correspondingly formed to be spaced apart from each other in the first direction D1.

By the second anisotropic etching process, a portion of the preliminary channel pattern 107 on the second region II of the first bulk substrate 100 covered by the seventh mask pattern 230 may be transformed into a dummy channel 109, and a portion of the preliminary channel pattern 107 not covered by the seventh mask pattern 230 may be removed to expose a portion of the first gate insulation pattern 202 under the seventh mask pattern 230.

Hereinafter, the first gate electrode 210, the capping pattern 220, the first gate insulation pattern 202 and the channels 108, the dummy channels 109 and the third spacer 232 on opposite sidewalls of the first gate insulation pattern 202 in the second direction D2 may be collectively referred to as an extension structure.

In example embodiments, the extension structure may extend in the first direction D1 and a plurality of extension structures may be spaced apart from each other in the second direction D2.

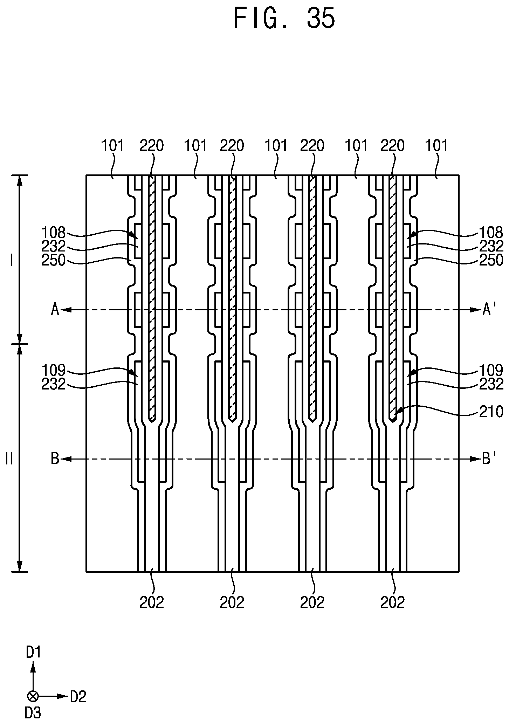

Referring to FIGS. 35 to 37, a second gate insulation pattern 250 may be formed on an outer sidewall of the extension structure.

In example embodiments, the second gate insulation pattern 250 may be formed by conformally forming a second gate insulation layer on the upper surface of the buried insulation layer 101 and the outer sidewall and an upper surface of the extension structure, and performing an anisotropic etching process on the second gate insulation layer.

In example embodiments, the second gate insulation pattern 250 may extend in the first direction D1 along each of the opposite sidewalls of the extension structure in the second direction D2, and a plurality of second gate insulation patterns 250 may be spaced apart from each other in the second direction D2 in a cross-sectional view.

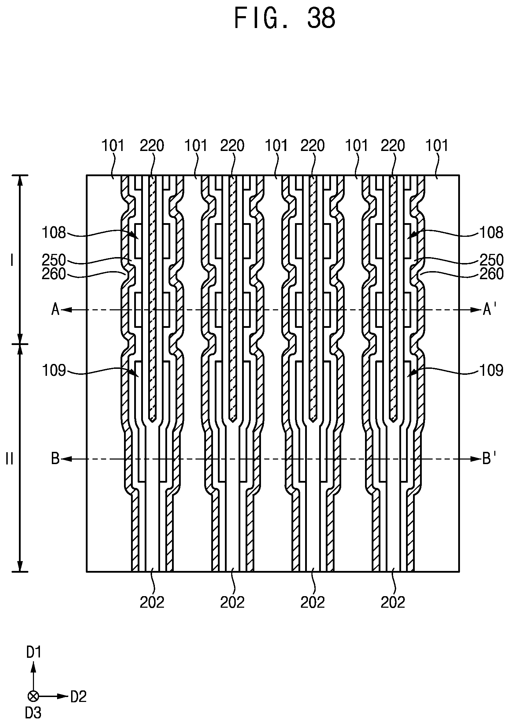

Referring to FIGS. 38 to 40, a second gate electrode 260 may be formed on an outer sidewall of the second gate insulation pattern 250.

In example embodiments, the second gate electrode 260 may be formed by conformally forming a second gate electrode layer on the upper surface of the buried insulation layer 101, the upper surface of the extension structure and the sidewall and an upper surface of the second gate insulation pattern 250, and performing an anisotropic etching process on the second gate electrode layer.

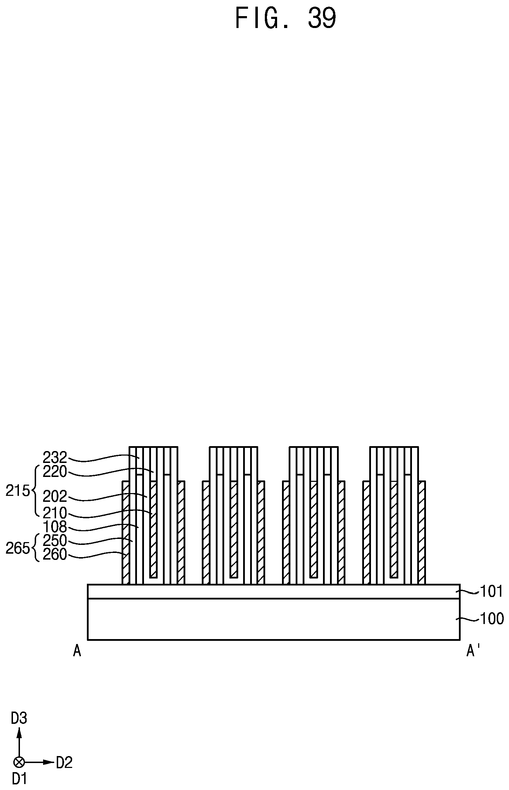

In example embodiments, a height level of an upper surface of the second gate electrode 260 may be lower than a height level of the upper surface of the second gate insulation pattern 250. FIG. 39 shows that the upper surface of the second gate electrode 260 is substantially parallel to the upper surface of the first bulk substrate 100, however the inventive concept is not be limited thereto, and for example, the upper surface of the second gate electrode 260 may become gradually higher as the upper surface of the second gate electrode 260 gets closer to the second gate insulation pattern 250.

The second gate electrode 260 and the second gate insulation pattern 250 may collectively form a second gate structure 265.

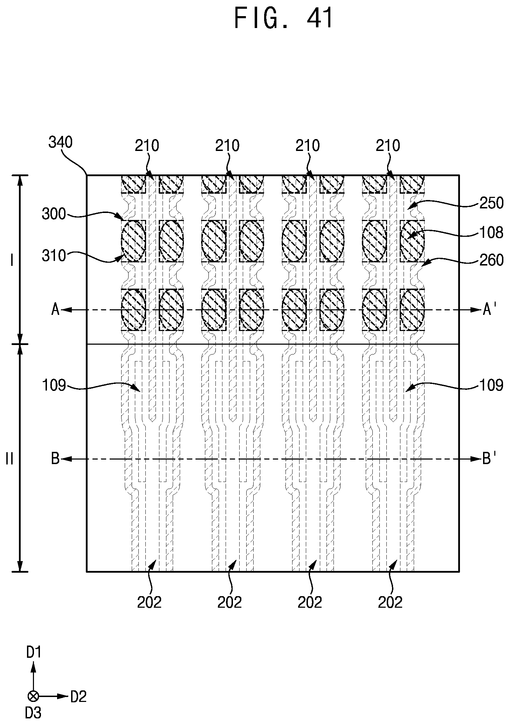

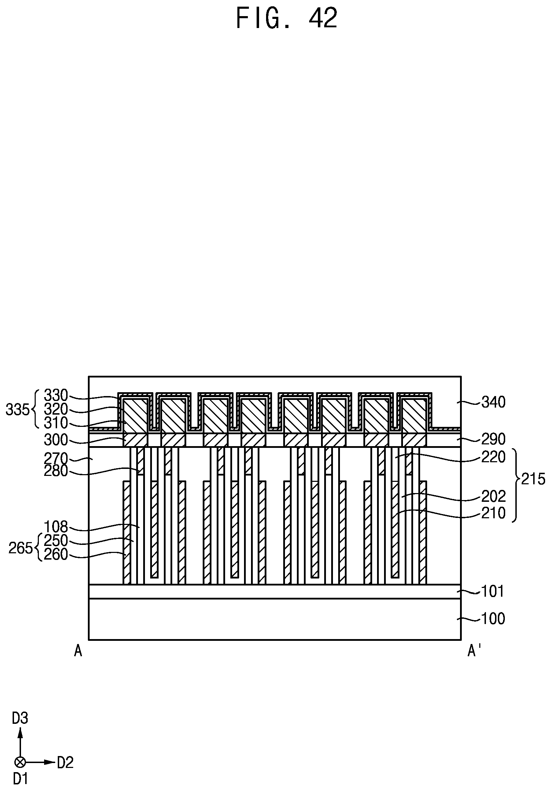

Referring to FIGS. 41 and 42, a gate division layer may be formed on the extension structure, the second gate insulation pattern 250, the second gate electrode 260 and the buried insulation layer 101, and a planarization process may be performed on the gate division layer until the upper surfaces of the capping pattern 220, the first gate insulation pattern 202, the third spacer 232 and the second gate insulation pattern 250 are exposed to form a gate division pattern 270.

The third spacer 232 may be removed to form a first opening exposing the upper surface of the channel 108, and a first contact plug 280 may be formed to fill the first opening.

In example embodiments, a plurality of first contact plugs 280 may be spaced apart from each other in each of the first and second directions D1 and D2 on the first region I of the first bulk substrate 100, and may contact the respective upper surfaces of corresponding ones of the channels 108.

A first insulating interlayer 290 may be formed on the gate division pattern 270, the second gate insulation pattern 250, the first contact plug 280, the first gate insulation pattern 202 and the capping pattern 220, and a landing pad 300 may be formed through the first insulating interlayer 290 to contact an upper surface of the first contact plug 280. In example embodiments, a plurality of landing pads 300 may be spaced apart from each other in each of the first and second directions D1 and D2 corresponding to ones of the first contact plug 280, respectively, and may be arranged in a grid shape or a honeycomb shape in a plan view.

A first capacitor electrode 310 may be formed to contact an upper surface of the landing pad 300, a dielectric pattern 320 may be formed on an upper surface and a sidewall of the first capacitor electrode 310 and the first insulating interlayer 290, and a second capacitor electrode 330 may be formed on the dielectric pattern 320. The first capacitor electrode 310, the dielectric pattern 320 and the second capacitor electrode 330, which may be sequentially stacked, may collectively form a capacitor 335.

In example embodiments, a plurality of first capacitor electrodes 310 may be spaced apart from each other in each of the first and second directions D1 and D2 and may contact the respective upper surfaces of corresponding ones of the landing pads 300.

An upper plate electrode 340 may be formed on the capacitor 335.

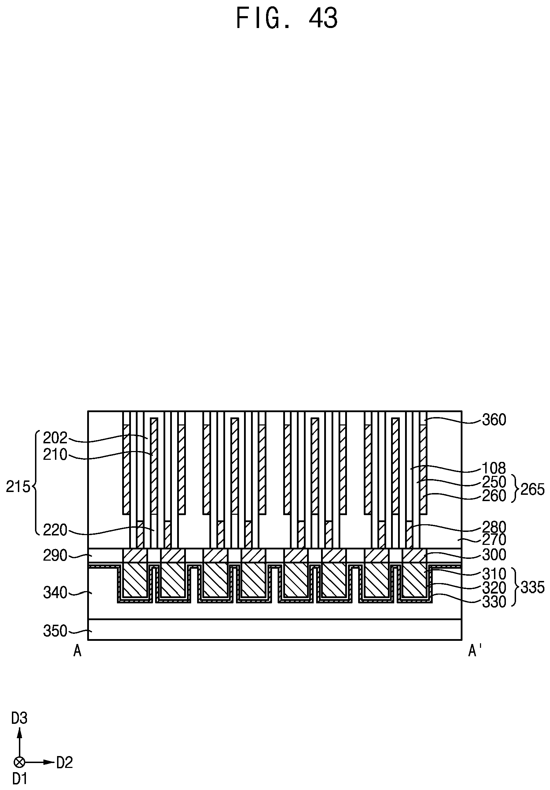

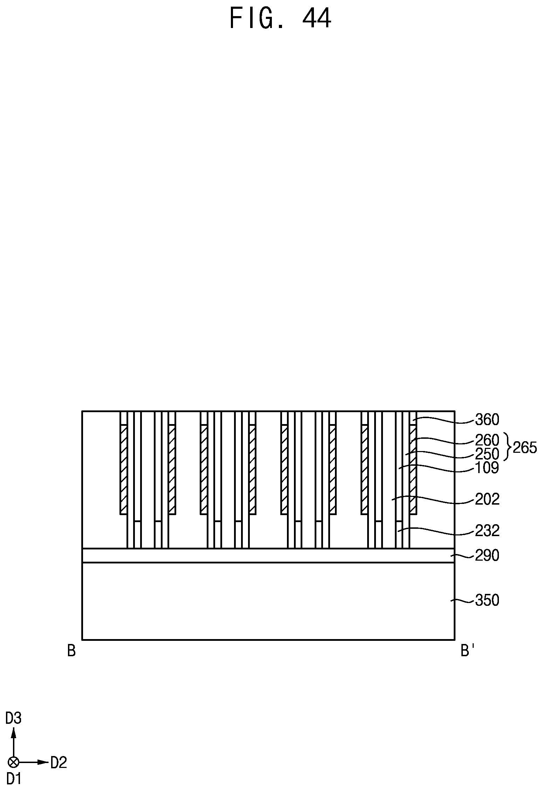

Referring to FIGS. 43 and 44, a second insulating interlayer 350 and a first bonding layer (not shown in the drawings) may be sequentially formed on the upper plate electrode 340, a handling substrate (not shown in the drawings) may be bonded to the first bonding layer via a second bonding layer (not shown in the drawings), the first bulk substrate 100 and the handling substrate, which may be bonded to each other, may be flipped, and the first bulk substrate 100 and the buried insulation layer 101 may be removed. Thus, structures on the first bulk substrate 100 may be flipped upside down, and hereinafter are illustrated based on the changed direction. The terms "upper" and "lower" in the following sections may refer to the respective orientations shown in the figures.

Upper surfaces of the first and second gate insulation patterns 202 and 250, the channel 108, the dummy channel 109, the second gate electrode 260 and the gate division pattern 270 may be exposed.

An upper portion of the second gate electrode 260 may be removed to form a recess, and a first insulation pattern 360 may be formed in the recess.

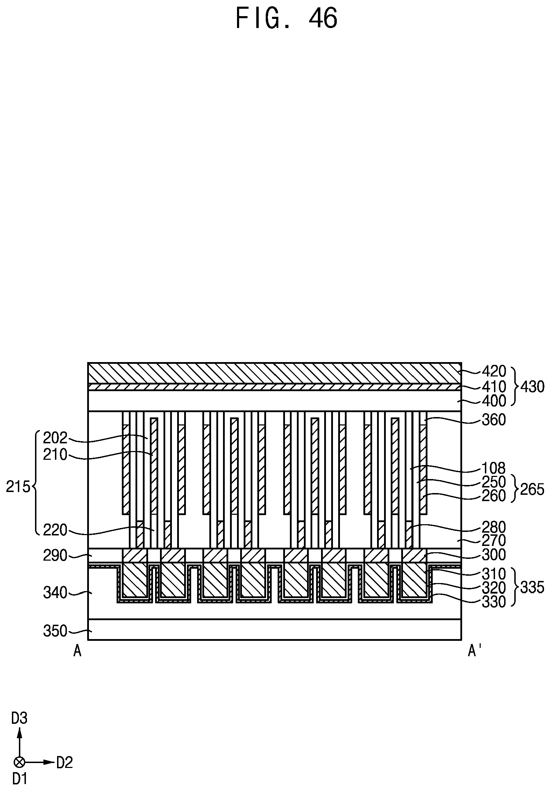

Referring to FIGS. 45 and 46, a first conductive layer, a barrier layer and a second conductive layer may be sequentially stacked on the first and second gate insulation patterns 202 and 250, the first insulation pattern 360, the channel 108 and the dummy channel 109, and an etching process may be performed to partially etch the first conductive layer, the barrier layer and the second conductive layer to form a first conductive pattern 400, a barrier pattern 410 and a second conductive pattern 420, respectively, which may form a bit line 430.

In example embodiments, the bit line 430 may extend in the second direction D2 in the first region I and a plurality of bit lines 430 may be spaced apart from each other in the first direction D1. A second opening 440 exposing the upper surfaces of the first and second gate insulation patterns 202 and 250 and the channel 108 and an upper surface of the first insulation pattern 360 may be formed between ones of the bit lines 430 adjacent to each other in the first direction D1.

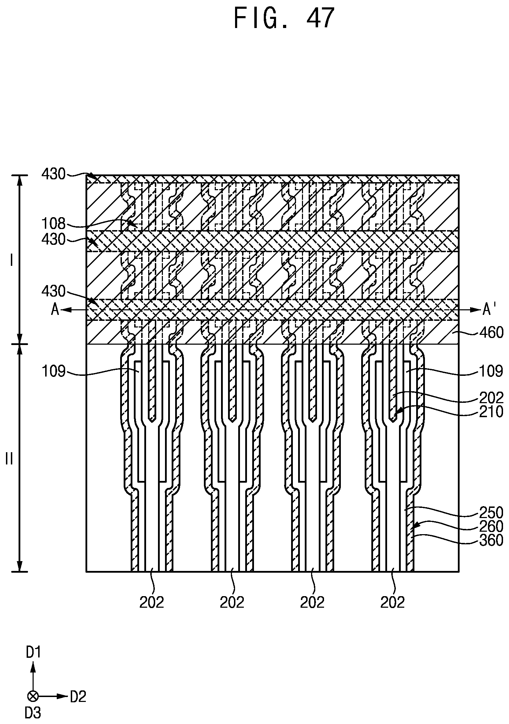

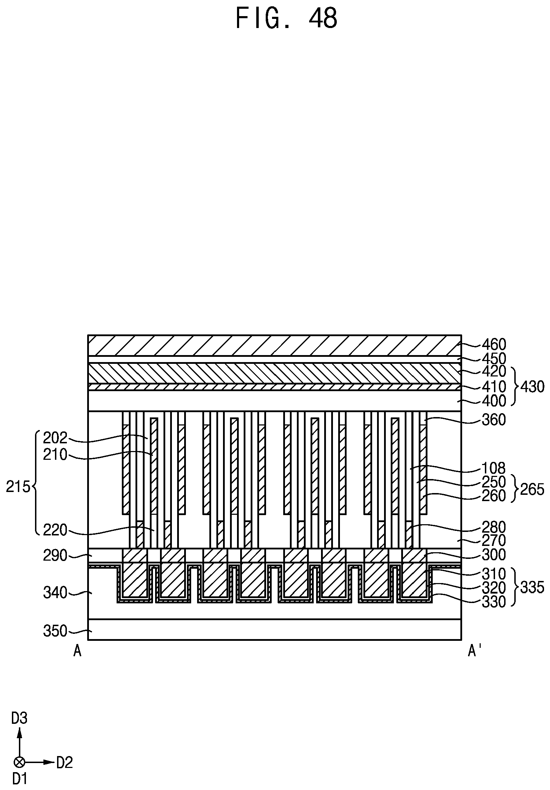

Referring to FIGS. 47 and 48, a second insulation layer may be formed on the bit line 430, the first and second gate insulation patterns 202 and 250, the first insulation pattern 360, the channel 108 and the dummy channel 109. A bit line shield layer, which may fill the second opening 440 and have an upper surface higher than an uppermost surface of the second insulation layer may be formed on the second insulation layer. The bit line shield layer may be partially removed to form a bit line shield structure 460 and the second insulation pattern 450, respectively, in the first region I.

The bit line shield structure 460 may include a bit line shield plate that may be formed at a height higher than an upper surface of the second insulation pattern 450, and a bit line shield fin that may be formed at a height lower than the upper surface of the second insulation pattern 450. In example embodiments, the bit line shield plate may have a flat plate shape, and the bit line shield fin may extend in the second direction D2. A plurality of bit line shield fins may be spaced apart from each other in the first direction D1. Each bit line shield fin may extend between a corresponding pair of adjacent bit lines 430 (e.g. adjacent in the first direction D1).

A third insulating interlayer 600 may be formed on the bit line shield structure 460, the first and second gate insulation patterns 202 and 250, the dummy channel 109, the first insulation pattern 360 and the gate division pattern 270.

Referring back to FIGS. 1A, 1B, 2 and 3, the handling substrate may be flipped, and the handling substrate and the first and second bonding layers may be removed to expose an upper surface of the second insulating interlayer 350.

A second contact plug 610 may be formed through a portion of each of the first and second insulating interlayers 290 and 350 in the second region II to contact and be electrically connected to the upper surface of the first gate electrode 210. The second contact plug 610 may contact not only the first gate electrode 210, but also portions of the first gate insulation pattern 202 and the dummy channel 109 adjacent to the first gate electrode 210.

In example embodiments, the second contact plug 610 may have a shape of, e.g., a square or a circle in a plan view, and a plurality of second contact plugs 610 may be spaced apart from each other in the second direction D2 to contact the respective upper surfaces of ones of corresponding first gate electrodes 210.

A third contact plug 620 may be formed through a portion of each of the first and second insulating interlayers 290 and 350 in the second region II to contact and be electrically connected to the upper surface of the second gate electrode 260. The third contact plug 620 may contact not only the second gate electrode 260, but also portions of the second gate insulation pattern 250 and the gate division pattern 270 adjacent to the second gate electrode 260.

In example embodiments, the third contact plug 620 may have a shape of, e.g., a square or a circle in a plan view, and a plurality of third contact plugs 620 may be spaced apart from each other in the second direction D2 to contact the respective upper surfaces of ones of corresponding second gate electrodes 260.

As illustrated above, the spacer 160 extending in the first direction D1 may be formed on the substrate, and the spacer 160 may be partially etched to form the first spacer 162 and the second spacer 165 having a width in the second direction D2 smaller than that of the first spacer 162 and contacting the first spacer 162. The first trench 190 and the second trench 192 having a width smaller than that of the first trench 190 may be formed by performing an etching process using the first and second spacers 162 and 165 as an etching mask, a deposition process and a planarization process may be performed to form the first gate insulation pattern 202 covering the inner wall of the first trench 190 and filling the second trench 192, and the first gate electrode 210 may be formed in a remaining portion of the first trench 190. The second gate insulation pattern 250 and the second gate electrode 260 may be sequentially formed on the sidewall of the first gate insulation pattern 202, and the second and third contact plugs 610 and 620 may be formed on the first and second gate electrodes 210 and 260, respectively.

If the first and second trenches 190 and 192 having different widths are formed by separate photo processes and etching processes, and then the first gate insulation pattern 202 and the first gate electrode 210 are formed therein, the number of processes may increase, and misalignment may occur between the first and second trenches 190 and 192, resulting in misalignment between the first gate electrode 210 in the first trench 190 and the second contact plug 610 in the second trench 192, or further, misalignment between the second gate electrode 260 on a side in the second direction D2 of the first gate electrode 210 and the third contact plug 620.

However, according to example embodiments, the first and second trenches 190 and 192 may be formed by an etching process using the first and second spacers 162 and 165 that may be formed from the same spacer 160 as an etching mask, so that the number of processes may decrease and misalignment between the gate electrodes and the contact plugs may not occur.

Embodiments are set out in the following Clauses:
1. A semiconductor device comprising:
   bit lines spaced apart from each other in a first direction, each of the bit lines extending in a second direction intersecting the first direction;
   a first gate electrode extending in the first direction on the bit lines;
   a first gate insulation pattern including two parts on respective opposite sidewalls in the second direction of the first gate electrode, each of the two parts extending in the first direction, wherein the two parts of the first gate insulation pattern are merged at an end portion in the first direction of the first gate electrode, and the merged portion extends in the first direction;
   channels on and electrically connected to the bit lines, respectively, the channels being on respective opposite sidewalls in the second direction of the first gate insulation pattern, and the channels being spaced apart from each other;
   a second gate insulation pattern on the opposite sidewalls in the second direction of the first gate insulation pattern, the second gate insulation pattern extending in the first direction and surrounding sidewalls of the channels; and
   a second gate electrode on each of opposite sidewalls in the second direction of the second gate insulation pattern, the second gate electrode extending in the first direction,
   wherein each of opposite outer sidewalls in the second direction of a portion of the first gate insulation pattern adjacent to the end portion in the first direction of the first gate electrode has a curved shape in a plan view.
2. The semiconductor device according to Clause 1, wherein a central portion in the second direction of the end portion in the first direction of the first gate electrode has a pointed shape in a plan view.
3. The semiconductor device according to Clause 1, wherein the end portion in the first direction of the first gate electrode has a curved shape in a plan view.
4. The semiconductor device according to any preceding Clause, further comprising a dummy channel on the each of opposite outer sidewalls in the second direction of the portion of the first gate insulation pattern adjacent to the end portion in the first direction of the first gate electrode, the dummy channel not being electrically connected to one of the bit lines,
   wherein each of the opposite outer sidewalls in the second direction of the dummy channel has a curved shape in a plan view.
5. The semiconductor device according to any preceding Clause, further comprising:
   a first contact plug contacting an upper surface of each of the channels; and
   a capping pattern covering an upper surface of the first gate electrode,
   wherein heights of upper surfaces of the capping pattern, the first gate insulation pattern, the first contact plug and the second gate insulation pattern are the same.
6. A semiconductor device comprising:
   a plurality of bit lines spaced apart from each other in a first direction, each of the plurality of bit lines extending in a second direction intersecting the first direction;
   a first gate electrode extending in the first direction on the plurality of bit lines, an end portion in the first direction of the first gate electrode having a central portion in the second direction that protrudes in the first direction, in a plan view;
   a first gate insulation pattern including:
      a first portion covering each of opposite sidewalls in the second direction and the end portion in the first direction of the first gate electrode, and
      a second portion contacting the first portion and extending in the first direction;
   a channel at each of opposite sides in the second direction of the first gate insulation pattern on the plurality of bit lines, the channel extending in a third direction substantially perpendicular to the first and second directions;
   a second gate insulation pattern and a second gate electrode sequentially stacked in the second direction at a side in the second direction of the channel on the plurality of bit lines;
   a capacitor on and electrically connected to the channel;
   a first contact plug contacting an upper surface of the first gate electrode; and
   a second contact plug contacting an upper surface of the second gate electrode.
7. The semiconductor device according to Clause 6,
   wherein the first contact plug contacts an upper surface of the first portion of the first gate insulation pattern, and
   wherein the second contact plug contacts an upper surface of the second gate insulation pattern.
8. The semiconductor device according to Clause 6 or Clause 7, wherein the first contact plug contacts an upper surface of the end portion of the first gate electrode.
9. The semiconductor device according to any of Clauses 6-8, further comprising:
   a plurality of first contact plugs spaced apart from each other by a first distance in the second direction, the first contact plug being one of the plurality of first contact plugs; and
   a plurality of second contact plugs spaced apart from each other by a second distance smaller than the first distance in the second direction, the second contact plug being one of the plurality of second contact plugs.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept. Accordingly, all such modifications are intended to be included within the scope of the present inventive concept as defined in the claims. In the claims, if any terms were to be considered as means-plus-function clauses, they are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

## Claims

1. A semiconductor device comprising:
a bit line (430) extending in a first direction (D2);
a first gate electrode (210) extending on the bit line (430) in a second direction (D1) intersecting the first direction (D2), wherein an end portion in the second direction (D1) of the first gate electrode (210) has a central portion with respect to the first direction (D2), and the end portion protrudes in the second direction (D1) in a plan view;
a first gate insulation pattern (202) including:
a first portion covering each of opposite sidewalls in the first direction (D2) and the end portion in the second direction (D1) of the first gate electrode (210), and
a second portion contacting the first portion and extending in the second direction (D1);
a channel (108) extending in a third direction (D3) substantially perpendicular to the first (D1) and second (D2) directions, the channel (108) being disposed on a side in the first direction (D2) of the first gate insulation pattern (202) on the bit line (430); and
a second gate insulation pattern (250) and a second gate electrode (260) sequentially arranged in the first direction (D2) on a side in the first direction (D2) of the channel (108) on the bit line (430).

2. The semiconductor device according to claim 1, wherein the central portion of the end portion in the second direction (D1) of the first gate electrode (210) has a pointed shape in a plan view.

3. The semiconductor device according to claim 1, wherein the central portion of the end portion in the second direction (D1) of the first gate electrode (210) has a curved shape in a plan view.

4. The semiconductor device according to any preceding claim, wherein each of opposite outer sidewalls in the first direction (D2) of the first portion of the first gate insulation pattern (202) adjacent to the second portion of the first gate insulation pattern (202) has a curved shape in a plan view.

5. The semiconductor device according to claim 4,
wherein the channel (108) contacts an upper surface of the bit line (430),
wherein the semiconductor device further comprises a dummy channel (109) extending in the third direction (D3), the dummy channel (109) being disposed on a side in the second direction (D1) of portions of the first (202) and second (250) gate insulation patterns which are adjacent to each other in the first direction (D2) on the bit line (430), and
wherein the dummy channel (109) does not contact the upper surface of the bit line (430).

6. The semiconductor device according to any preceding claim, wherein the first portion of the first gate insulation pattern (202) covers a lower surface of the first gate electrode (210).

7. The semiconductor device according to any preceding claim, wherein:
in a plan view, the first portion of the first gate insulation pattern (202) includes two parts, and the first gate electrode (210) is disposed between the two parts, and
a width (WD1) in the first direction (D2) of one of the two parts is less than 60% of a width (WD2) in the first direction (D2) of the second portion of the first gate insulation pattern (202).

8. The semiconductor device according to any preceding claim, further comprising an insulation pattern (360) between the second gate electrode (260) and the bit line (430), the insulation pattern (360) separating the second gate electrode (260) and the bit line (430) apart from each other.

9. The semiconductor device according to any preceding claim, further comprising a gate division pattern (270) on the bit line (430), the gate division (270) pattern including:
a first portion covering a sidewall in the first direction (D2) of the second gate electrode (260); and
a second portion on and contacting the first portion, the second portion of the gate division pattern (270) covering an upper surface of the second gate electrode (260) and having a width in the first direction (D2) greater than a width in the first direction (D2) of the first portion.

10. The semiconductor device according to any preceding claim, further comprising:
a first contact plug (280) contacting an upper surface of the channel (108);
a landing pad (300) on the first contact plug (280); and
a capacitor (335) on the landing pad (300).

11. The semiconductor device according to claim 10, further comprising:
a second contact plug (610) contacting an upper surface of the first gate electrode (210) and an upper surface of the first portion of the first gate insulation pattern (202); and
a third contact plug (620) contacting an upper surface of the second gate electrode (260) and an upper surface of the second gate insulation pattern (250).

12. A semiconductor device according to any preceding claim, further comprising:
a plurality of bit lines spaced apart from each other in the second direction (D1), each of the bit lines extending in the first direction (D2), wherein the plurality of bit lines comprise the bit line (430);
a plurality of channels on and electrically connected to the bit lines, respectively, the channels comprising the channel (108), the channels being on respective opposite sidewalls in the first direction (D2) of the first gate insulation pattern (202), and the channels being spaced apart from each other;
wherein the first gate insulation pattern (202) includes two parts on respective opposite sidewalls in the first direction (D2) of the first gate electrode (210), each of the two parts extending in the second direction (D1), wherein the two parts of the first gate insulation pattern (202) are merged at the end portion in the second direction (D1) of the first gate electrode (210), and the second portion extends from the merged portion in the second direction (D1);
wherein the second gate insulation pattern (250) is on the opposite sidewalls in the first direction (D2) of the first gate insulation pattern (202), the second gate insulation pattern (250) extending in the second direction (D1) and surrounding sidewalls of the channels; and
wherein second gate electrodes (260) are provided on each of opposite sidewalls in the first direction (D2) of the second gate insulation pattern (250), the second gate electrodes (260) extending in the second direction (D1),
wherein each of opposite outer sidewalls in the first direction (D2) of a portion of the first gate insulation pattern (202) adjacent to the end portion in the second direction (D1) of the first gate electrode (210) has a curved shape in a plan view.

13. A semiconductor device according to any of claims 1-9, the semiconductor device further comprising:
a plurality of bit lines spaced apart from each other in the second direction (D1), each of the plurality of bit lines extending in the first direction, wherein the plurality of bit lines comprise the bit line (430);
a capacitor (335) on and electrically connected to the channel (108);
a first contact plug (610) contacting an upper surface of the first gate electrode (210); and
a second contact plug (620) contacting an upper surface of the second gate electrode (260),
wherein the first gate electrode (210) extends in the second direction (D1) on the plurality of bit lines,
wherein the channel (108) is at each of opposite sides in the first direction (D2) of the first gate insulation pattern (202) on the plurality of bit lines, and
wherein the second gate insulation pattern (250) and the second gate electrode (260) are on the plurality of bit lines.
